# EUROPEAN PATENT APPLICATION

(11) **EP 4 415 034 A1**
(43) Date of publication of application: **14.08.2024**
(21) Application number: 24150884.5
(22) Date of filing: 09.01.2024
(51) Int. Cl.: H01L 21/768, H01L 21/8234, H01L 23/48, H01L 23/528, H01L 29/423, H01L 23/522, H01L 29/775, H01L 21/822, H01L 27/06

(54) **INTEGRATED CIRCUIT INCLUDING BACKSIDE WIRING AND METHOD OF DESIGNING THE INTEGRATED CIRCUIT**

(30) Priority: 08.02.2023 KR 20230016992; 30.06.2023 KR 20230085281
(71) Applicant: Samsung Electronics Co., Ltd., Suwon-si, Gyeonggi-do 16677 (KR)
(72) Inventor: LEE, Seungmin, 16677 Suwon-si (KR); KIM, Changbeom, 16677 Suwon-si (KR); DO, Jungho, 16677 Suwon-si (KR); KIM, Wookyu, 16677 Suwon-si (KR)
(74) Representative: Marks & Clerk LLP

(57) **Abstract**

An integrated circuit includes a power rail extending in a first direction and configured to receive a supply voltage, a gate line below the power rail and extending in a second direction that intersects the first direction, a source/drain region adjacent to the gate line in the first direction and configured to receive the supply voltage from the power rail, a frontside wiring layer above the power rail, connected to the power rail, and configured to transmit the supply voltage to the power rail, and a backside wiring layer below the power rail, connected to the power rail, and configured to transmit the supply voltage to the power rail.

## Description

### BACKGROUND

Example embodiments of the disclosure relate to an integrated circuit, and more particularly, to an integrated circuit including backside wiring, and a method of designing the integrated circuit.

Due to the demand for a high degree of integration and the development of semiconductor processes, a width, interval, and/or height of wires included in an integrated circuit may be decreased, and effects of parasitic elements of the wires may be increased. In addition, for reduced power consumption, higher operation speed, etc., a power supply voltage of an integrated circuit may be reduced and accordingly, effects on an integrated circuit caused by parasitic elements of wires may become more significant. Accordingly, there has been a growing demand for a method of designing an integrated circuit efficiently routing wires and vias.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide an integrated circuit capable of reducing routing complexity using a frontside wiring layer and a backside wiring layer and decreasing source resistance of transistors and a method of designing the integrated circuit.

Additional aspects will be set forth in part in the description which follows and, in part, will be apparent from the description, or may be learned by practice of the presented embodiments.

According to an aspect of an example embodiment, an integrated circuit includes a power rail extending in a first direction and configured to receive a supply voltage, a gate line below the power rail and extending in a second direction that intersects the first direction, a source/drain region adjacent to the gate line in the first direction and configured to receive the supply voltage from the power rail, a frontside wiring layer above the power rail, connected to the power rail, and configured to transmit the supply voltage to the power rail, and a backside wiring layer below the power rail, connected to the power rail, and configured to transmit the supply voltage to the power rail.

According to an aspect of an example embodiment, an integrated circuit includes a source region, a drain region spaced apart from the source region in a first direction, a gate line between the source region and the drain region, the gate line extending in a second direction that intersects the first direction, a frontside wiring layer above the gate line, and a backside wiring layer below the gate line, where the frontside wiring layer includes a first frontside wiring pattern extending in the first direction, connected to the source region, and configured to transmit a supply voltage to the source region, and the backside wiring layer includes a first backside wiring pattern connected to the source region and configured to transmit the supply voltage to the source region.

According to an aspect of an example embodiment, an integrated circuit includes a standard cell including a first frontside wiring layer including a power rail and an internal rail, where each of the power rail and the internal rail extends in a first direction, a gate line below the first frontside wiring layer and extending in a second direction that intersects the first direction, a second frontside wiring layer above the first frontside wiring layer and connected to the internal rail and a backside wiring layer below the gate line and connected to the power rail.

According to an aspect of an example embodiment, an integrated circuit includes a standard cell including a first frontside wiring layer including a power rail and an internal rail each extending in a first direction, where the power rail is spaced apart from the internal rail in a second direction that intersects the first direction, a gate line below the first frontside wiring layer and extending in the second direction, a source/drain region adjacent to the gate line in the first direction, a second frontside wiring layer above the first frontside wiring layer, and a backside wiring layer below the source/drain region, where the second frontside wiring layer includes a first frontside wiring pattern connected to the internal rail and the backside wiring layer includes a first backside wiring pattern connected to the source/drain region.

At least some of the above and other features of the invention are set out in the claims.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram of an integrated circuit according to an embodiment;
FIG. 2A is a plan view of the front side of an integrated circuit, according to an embodiment;
FIG. 2B is a plan view of the back side of an integrated circuit, according to an embodiment;
FIG. 3 is a perspective view of a power distribution network (PDN), according to an embodiment;
FIG. 4 is a circuit diagram corresponding to a first region of an integrated circuit, according to an embodiment;
FIG. 5A is a cross-sectional view taken along line X1-X1' of FIG. 1, according to an embodiment;
FIG. 5B is a cross-sectional view taken along line X2-X2' of FIG. 1, according to an embodiment;
FIG. 5C is a cross-sectional view taken along line X3-X3' of FIG. 1, according to an embodiment;
FIG. 6A is a diagram of an integrated circuit according to an embodiment;
FIG. 6B is a cross-sectional view taken along line X4-X4' of FIG. 6A according to an embodiment;
FIG. 6C is a cross-sectional view taken along line X5-X5' of FIG. 6A according to an embodiment;
FIG. 7A is a diagram of an integrated circuit according to an embodiment;
FIG. 7B is a cross-sectional view taken along line X6-X6' of FIG. 7A according to an embodiment;
FIG. 7C is a cross-sectional view taken along line X7-X7' of FIG. 7A according to an embodiment;
FIG. 8A is a diagram of an integrated circuit according to an embodiment;
FIG. 8B is a cross-sectional view taken along line X8-X8' of FIG. 8A according to an embodiment;
FIG. 8C is a cross-sectional view taken along line X9-X9' of FIG. 8A according to an embodiment;
FIG. 9A is a diagram of an integrated circuit according to an embodiment;
FIG. 9B is a cross-sectional view taken along line X10-X10' of FIG. 9A according to an embodiment;
FIG. 9C is a cross-sectional view taken along line X11-X11' of FIG. 9A according to an embodiment;
FIG. 10A is a diagram of an integrated circuit according to an embodiment;
FIG. 10B is a cross-sectional view taken along line X12-X12' of FIG. 10A according to an embodiment;
FIG. 10C is a cross-sectional view taken along line X13-X13' of FIG. 10A according to an embodiment;
FIG. 11A is a diagram of an integrated circuit according to an embodiment;
FIG. 11B is a cross-sectional view taken along line X14-X14' of FIG. 11A according to an embodiment;
FIG. 11C is a cross-sectional view taken along line X15-X15' of FIG. 11A according to an embodiment;
FIG. 12 is a diagram of an integrated circuit according to an embodiment;
FIG. 13 is a schematic perspective view of a PDN, according to an embodiment;
FIG. 14A is a diagram of an integrated circuit according to an embodiment;
FIG. 14B is a circuit diagram corresponding to a component of FIG. 14A, according to an embodiment;
FIG. 14C is a diagram of an integrated circuit, according to an embodiment;
FIG. 15A is a diagram of an integrated circuit according to an embodiment;
FIG. 15B is a circuit diagram corresponding to a component of FIG. 15A, according to an embodiment;
FIG. 15C is a diagram of an integrated circuit according to an embodiment;
FIG. 16A is a diagram of an integrated circuit according to an embodiment;
FIG. 16B is a circuit diagram corresponding to a part of FIG. 16A, according to an embodiment;
FIGS. 17A to 17D are diagrams of a device according to some embodiments;
FIG. 18 is a flowchart illustrating a method of manufacturing an integrated circuit, according to an embodiment;
FIG. 19 is a block diagram of a system-on-chip according to an embodiment; and
FIG. 20 is a block diagram of a computing system including a memory storing a program according to an embodiment.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

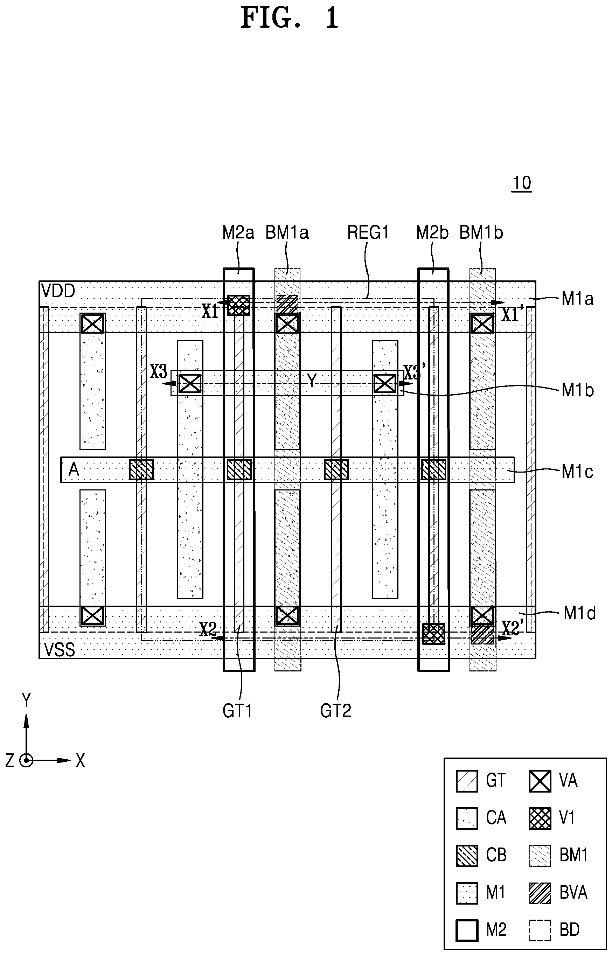

FIG. 1 is a diagram of an integrated circuit 10 according to an embodiment.

Referring to FIG. 1, the integrated circuit 10 may include gate lines GT, source/drain contacts CA, gate contacts CB, a first frontside wiring layer M1, a second frontside wiring layer M2, first vias VA, second vias V1, a backside wiring layer BM1, and backside vias BVA. The first frontside wiring layer M1 may include first frontside wiring patterns M1a, M1b, M1c, and M1d, and the second frontside wiring layer M2 may include second frontside wiring patterns M2a and M2b. The backside wiring layer BM1 may include backside wiring patterns BM1a and BM1b. According to an embodiment, the integrated circuit 10 may be referred to as an "integrated circuit device" or a "semiconductor device." For example, the gate lines GT, the source/drain contacts CA, and the gate contacts CB may constitute one standard cell, and the standard cell may be defined by a cell boundary BD.

The integrated circuit 10 may be designed by arranging a plurality of standard cells. The standard cell may be a unit of a layout of the integrated circuit 10 and may be referred to as a "cell" in an embodiment. The standard cell may be designed to include a plurality of transistors to perform a predefined function. Such a standard cell method may be a method of designing a large-scale integrated circuit dedicated to a provided specifications or a use by first preparing standard cells having various functions and combining the standard cells. The standard cell may be designed and verified beforehand and then registered at a standard cell library, and the integrated circuit 10 may be designed by performing designing of a logic through combination of the standard cells using computer-aided design (CAD), placement, and routing. When designing the integrated circuit 10, the performance of the integrated circuit 10 may be further improved by reducing the length of the wires and/or vias and the routing complexity.

According to an embodiment, the integrated circuit 10 may include the first and second frontside wiring layers M1 and M2 and the backside wiring layer BM1, and a power distribution network (PDN) using the first and second frontside wiring layers M1 and M2 and the backside wiring layer BM1. Accordingly, some of signals and/or powers (voltages) applied to the source/drain regions and/or the gate lines GT may be transmitted through the first and second frontside wiring layers M1 and M2, and the rest may be transmitted through the backside wiring layer BM1. As a result, according to an embodiment, the routing complexity may be reduced significantly in comparison with a structure in which wires are arranged only on a front side of a substrate, and the length of each wiring or via may be reduced as well. As such, the performance of the integrated circuit 10 may be improved.

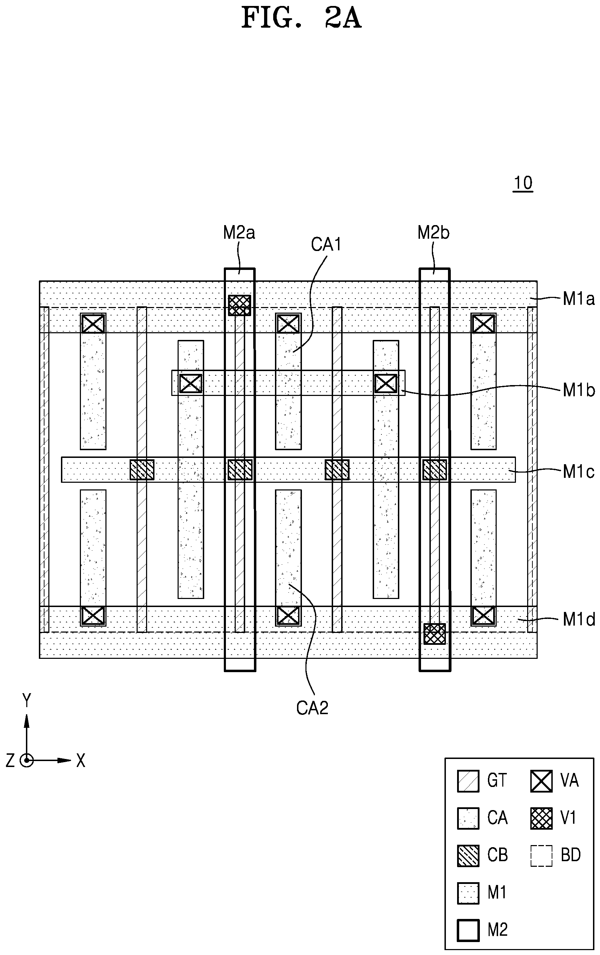

FIG. 2A is a plan view of a front side of the integrated circuit 10 of FIG. 1 according to an embodiment.

Referring to FIGS. 1 and 2A, the integrated circuit 10 may be implemented as a semiconductor device, and a substrate on which the semiconductor device is formed may include a first side and a second side. The first side may be, for example, a side on which circuit elements such as transistors are arranged, and the first side may be referred to as a "front side." The second side may be a side facing the first side, and the second side may be referred to as a "back side."

The gate lines GT may be arranged apart from each other in a first direction on a front side of a substrate and may each extend in a second direction which intersects the first direction. The first direction may be referred to as a first horizontal direction, the second direction may be referred to as a second horizontal direction. The first direction may be an X direction, and the second direction may be a Y direction which may be perpendicular to each other. A plane formed by the first direction (X) and the second direction (Y) may be referred to as a horizontal plane. For example, the gate lines GT may include a first gate line GT1 and a second gate line GT2. The gate lines GT may be defined as a conductive segment including a conductive material such as polysilicon, at least one metal, etc.

The source/drain contacts CA may respectively be arranged on source/drain regions on the front side of the substrate. According to an embodiment, the source/drain contacts CA may be referred to as source/drain contact patterns or source/drain contact plugs. The source/drain regions may include an epitaxial region of a semiconductor material such as silicon, boron, phosphorus, carbon, SiGe, and/or SiC. The gate contacts CB may respectively be arranged on the gate lines GT. According to an embodiment, the gate contacts CB may be referred to as gate contact patterns or gate contact plugs.

The first frontside wiring layer M1 may include a plurality of patterns (for example, a plurality of conductive patterns including a conductive material). A "pattern" may refer to a conductive pattern. For example, the first frontside wiring layer M1 may include the first frontside wiring patterns M1a to M1d each extending in the first direction (X). In this regard, a pattern extending in one direction may be referred to as a "line," and accordingly, the first frontside wiring patterns M1a to M1d may be referred to as first frontside wiring lines.

In an embodiment, the first frontside wiring pattern M1a may receive a first voltage, e.g., a positive supply voltage (e.g., VDD), and the first frontside wiring pattern M1d may receive a second voltage, e.g., a negative supply voltage (e.g., VSS). Accordingly, the first frontside wiring patterns M1a and M1d may be referred to as "power rails." The first frontside wiring pattern M1c may correspond to an input node, and the gate lines GT may each be connected to the first frontside wiring pattern M1c through the gate contacts CB. The first frontside wiring pattern M1b may correspond to an output node, and some of the source/drain regions may be connected to the first frontside wiring pattern M1b through the source/drain contacts CA.

The second frontside wiring layer M2 may include a plurality of patterns including a conductive material. For example, the second frontside wiring layer M2 may include second frontside wiring lines each extending in the second direction (Y) or the second frontside wiring patterns M2a and M2b. The first frontside wiring pattern M1a may be connected to the second frontside wiring pattern M2a through a corresponding second via V1. The first frontside wiring pattern M1d may be connected to the second frontside wiring pattern M2b through a corresponding second via V1.

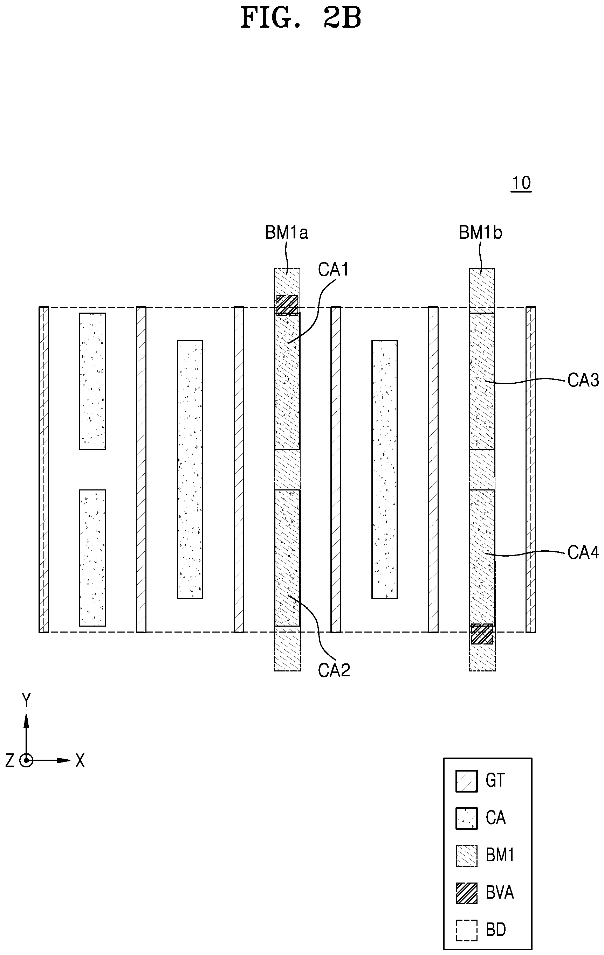

FIG. 2B is a plan view of a back side of the integrated circuit 10 of FIG. 1 according to an embodiment.

Referring to FIGS. 1 and 2B, the gate lines GT and the source/drain contacts CA are illustrated to describe positions of components arranged on the back side of the integrated circuit 10. The backside wiring layer BM1 may include the backside wiring patterns BM1a and BM1b each extending in the second direction (Y). For example, the backside wiring pattern BM1a may be arranged to at least partially overlap a first source/drain contact CA1 and a second source/drain contact CA2 which are arranged in a line in the second direction (Y), and the backside wiring pattern BM1b may be arranged to at least partially overlap a third source/drain contact CA3 and a fourth source/drain contact CA4 which are arranged in a line in the second direction (Y).

However, the disclosure is not limited thereto. In some embodiments, the backside wiring layer BM1 may include backside wiring patterns each extending in the first direction (X), and the backside wiring patterns each extending in the first direction (X) may partially overlap the first wiring pattern M1a or M1d. In some embodiments, the backside wiring layer BM1 may include a backside wiring pattern extending in the first direction (X) and a backside wiring pattern in the second direction (Y). As such, the arrangement and/or extending direction of the backside wiring layer BM1 may vary according to an embodiment.

The backside vias BVA may respectively be arranged on the backside wiring patterns BM1a and BM1b. The backside via BVA may connect layers and elements on the back side to contacts (e.g., CA1 to CA4), a via (e.g., VA of FIG. 2A), or a frontside wiring layer (e.g., M1 of FIG. 2A) on the substrate. The backside wiring pattern BM1a may be electrically connected to the first frontside wiring pattern M1a arranged on the front side of the substrate through a corresponding backside via BVA. In addition, the backside wiring pattern BM1b may be electrically connected to the first frontside wiring pattern M1d arranged on the front side of the substrate through a corresponding backside via BVA.

In an embodiment, the backside vias BVA may overlap the cell boundary BD of the standard cell. However, the disclosure is not limited thereto. For example, the backside vias BVA may be arranged in the standard cell. For example, the backside vias BVA may be arranged out of the cell boundary BD of the standard cell. In some embodiments, a backside contact may be further arranged on or under the backside via BVA, and accordingly, the backside wiring layer BM1 may be electrically connected to the first frontside wiring layer M1 through the backside via BVA and the backside contact. In an embodiment, the integrated circuit 10 may include a contact (e.g., a backside contact) and a contact via (e.g., a backside contact via), the contact may extend in the vertical direction (Z) on the backside via, the contact via may be on the contact, and the backside wiring layer BM1 may be connected to the power rail PR through the backside via BVA, the contact, and the contact via.

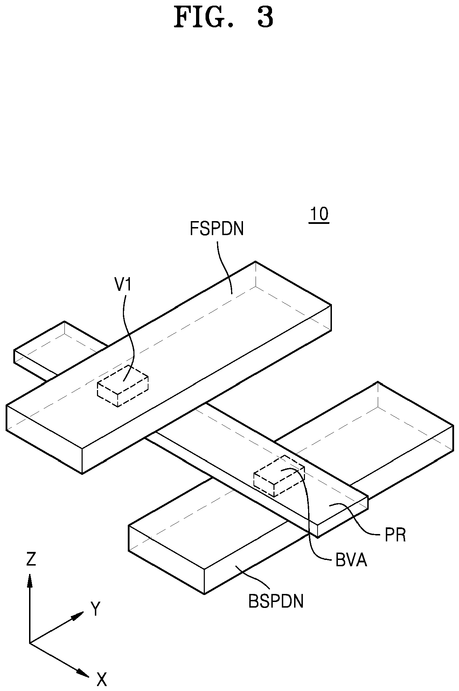

FIG. 3 is a perspective view of a power distribution network (PDN) of FIG. 1 according to an embodiment.

Referring to FIG. 3, a power rail PR receiving a first voltage or a second voltage may extend in the first direction (X). For example, the power rail PR may be arranged to overlap the cell boundary (e.g., BD of FIG. 1) of the standard cell in a vertical direction (Z). The power rail PR may correspond to the first frontside wiring pattern M1a or M1d of FIG. 1.

A frontside wiring layer FSPDN may extend in the second direction (Y) on the power rail PR in the vertical direction (Z) and may be electrically connected to the power rail PR through the second via V1. For example, the frontside wiring layer FSPDN may be connected to the power rail PR through a power rail via, which is on the power rail PR. For example, the frontside wiring layer FSPDN may correspond to the second frontside wiring pattern M2a or M2b of FIG. 1. However, the disclosure is not limited thereto, and the frontside wiring layer FSPDN may extend in the same direction as the extending direction of the power rail PR, for example, in the first direction (X).

A backside wiring layer BSPDN may extend in the second direction (Y) under the power rail PR in the vertical direction (Z) and may be electrically connected to the power rail PR through the backside via BVA. For example, the backside wiring layer BSPDN may correspond to the backside wiring pattern BM1a or BM1b of FIG. 1. However, the disclosure is not limited thereto, and the backside wiring layer BSPDN may extend in the same direction as the extending direction of the power rail PR, for example, in the first direction (X).

In an embodiment, the frontside wiring layer FSPDN does not overlap the backside wiring layer BSPDN in the vertical direction (Z). However, the disclosure is not limited thereto, and in some embodiments, the frontside wiring layer FSPDN and the backside wiring layer BSPDN may at least partially overlap in the vertical direction (Z). As such, the arrangement and/or extending direction of the frontside wiring layer FSPDN and the backside wiring layer BSPDN may vary according to an embodiment.

According to the embodiment, the power rail PR is arranged between the frontside wiring layer FSPDN and the backside wiring layer BSPDN. The power rail PR can receive a supply voltage from the frontside wiring layer FSPDN and receive a supply voltage from the backside wiring layer BSPDN. As such, the power rail PR is connected to the frontside wiring layer FSPDN and the backside wiring layer BSPDN and receives a supply voltage from the frontside wiring layer FSPDN and the backside wiring layer BSPDN. Accordingly, a parallel power rail may be implemented.

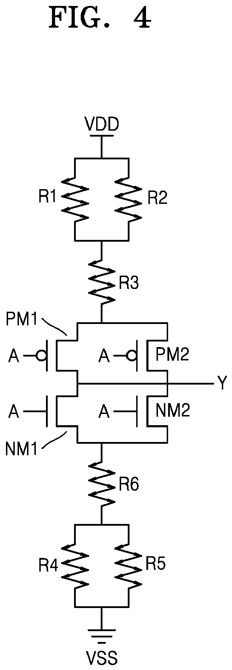

FIG. 4 is a circuit diagram corresponding to a first region REG1 of FIG. 1 according to an embodiment.

Referring to FIGS. 1 to 4, the first region REG1 may be a part of the integrated circuit 10 and include first and second p-type metal-oxide-semiconductor (MOS) (PMOS) transistors PM1 and PM2 and first and second n-type MOS (NMOS) transistors NM1 and NM2. The first PMOS transistor PM1 and the first NMOS transistor NM1 may be connected in series, and the second PMOS transistor PM2 and the second NMOS transistor NM2 may be connected in series.

Gates of the first and second PMOS transistors PM1 and PM2 and the first and second NMOS transistors NM1 and NM2 may receive a first control signal A. For example, the gates of the first PMOS transistor PM1 and the first NMOS transistor NM1 may correspond to the gate line GT1, and the gates of the second PMOS transistor PM2 and the second NMOS transistor NM2 may correspond to the gate line GT2. For example, the first control signal A may be received through the first frontside wiring pattern M1c. Drains of the first and second PMOS transistors PM1 and PM2 and the first and second NMOS transistors NM1 and NM2 may be connected to an output node Y. For example, the output node Y may correspond to the first frontside wiring pattern M1b.

Sources of the first and second PMOS transistors PM1 and PM2 may be connected to the first source/drain contact CA1, and the first source/drain contact CA1 may receive a first voltage (for example, a power voltage VDD). Sources of the first and second NMOS transistors NM1 and NM2 may be connected to the second source/drain contact CA2, and the second source/drain contact CA2 may receive a second voltage (for example, a ground voltage VSS).

Due to the sophisticated semiconductor process, the width of metal wiring has decreased, and the resistance has increased. The improvement in resistance has great effects on the power performance area (PPA) gain. For example, when implementing an integrated circuit using a double source transistor cell in which two transistors are respectively connected to two source contacts, the resistance may be reduced by connecting one source to one transistor. Such reduced resistance of source may lead to improvement of the integrated circuit. However, due to the addition of source, the area of the integrated circuit may increase.

However, according to the embodiment, by connecting the parallel power rail to one source commonly connected to the first and second PMOS transistors PM1 and PM2 (in other words, by implementing a one-source parallel power rail structure), the resistance of the source may be reduced, and the performance of the integrated circuit 10 may be improved without increasing the area. More specifically, the power voltage VDD may be supplied to the first source/drain contact CA1 connected to source of the first and second PMOS transistors PM1 and PM2 through the backside wiring layer BM1 on the back side of the substrate, the backside via BVA, and the first frontside wiring layer M1. Further, the power voltage VDD may be supplied to the first source/drain contact CA1 connected to the source of the first and second PMOS transistors PM1 and PM2 through the second frontside wiring layer M2, the second via V1, and the first frontside wiring layer M1 on the front side of the substrate.

For example, resistor R1 may correspond to the second frontside wiring pattern M2a, resistor R2 may correspond to the backside wiring pattern BM1a, and resistor R3 may correspond to the first source/drain contact CA1. As such, without increasing the area of the integrated circuit 10, by supplying the power voltage VDD in parallel to the first source/drain contact CA1 connected to the source of the first and second PMOS transistors PM1 and PM2, the source resistance of the first and second PMOS transistors PM1 and PM2 may be reduced, and the performance of the integrated circuit 10 may be improved.

In addition, according to the embodiment, by connecting the parallel power rail to one source commonly connected to the first and second NMOS transistors NM1 and NM2 (in other words, by implementing a one-source parallel power rail structure), the resistance of the source may be reduced, and the performance of the integrated circuit 10 may be improved without increasing the area. More specifically, the ground voltage VSS may be supplied to the second source/drain contact CA2 connected to source of the first and second NMOS transistors NM1 and NM2 through the backside wiring layer BM1 on the back side of the substrate, the backside via BVA, and the first frontside wiring layer M1. Further, the ground voltage VSS may be supplied to the second source/drain contact CA2 connected to the source of the first and second NMOS transistors NM1 and NM2 through the second frontside wiring layer M2, the second via V1, and the first frontside wiring layer M1 on the front side of the substrate.

For example, resistor R4 may correspond to the second frontside wiring pattern M2b, resistor R5 may correspond to the backside wiring pattern BM1b, and resistor R6 may correspond to the second source/drain contact CA2. As such, without increasing the area of the integrated circuit 10, by supplying the ground voltage VSS in parallel to the second source/drain contact CA2 connected to the source of the first and second NMOS transistors NM1 and NM2, the source resistance of the first and second NMOS transistors NM1 and NM2 may be reduced, and the performance of the integrated circuit 10 may be improved.

According to an embodiment illustrated in FIGS. 1 to 4, the parallel power rail supplying the power voltage VDD may be connected to the source of the first and second PMOS transistors PM1 and PM2, and the parallel power rail supplying the ground voltage VSS may be connected to the source of the first and second NMOS transistors NM1 and NM2. However, the disclosure is not limited thereto, and in some embodiments, the power voltage VDD may be supplied only to the source of the first and second PMOS transistors PM1 and PM2 using the frontside wiring layer FSPDN and the backside wiring layer BSPDN without connecting the parallel power rail to the source of the first and second NMOS transistors NM1 and NM2. In some embodiments, the ground voltage VSS may be supplied only to the source of the first and second NMOS transistors NM1 and NM2 using the frontside wiring layer FSPDN and the backside wiring layer BSPDN without connecting the parallel power rail to the source of the first and second PMOS transistors PM1 and PM2.

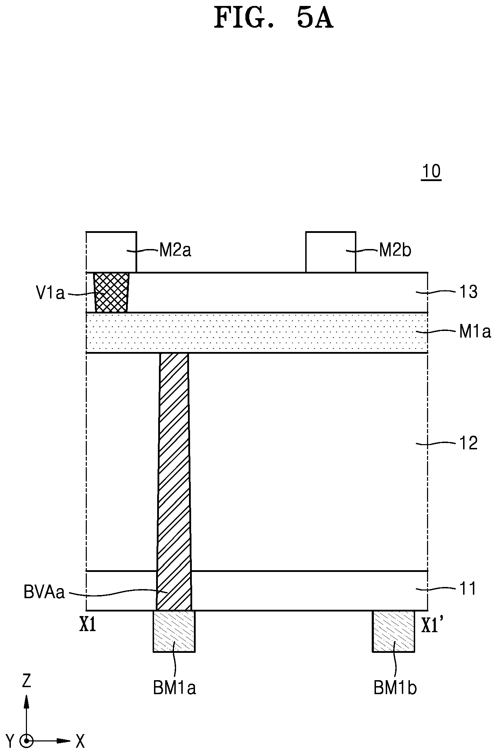

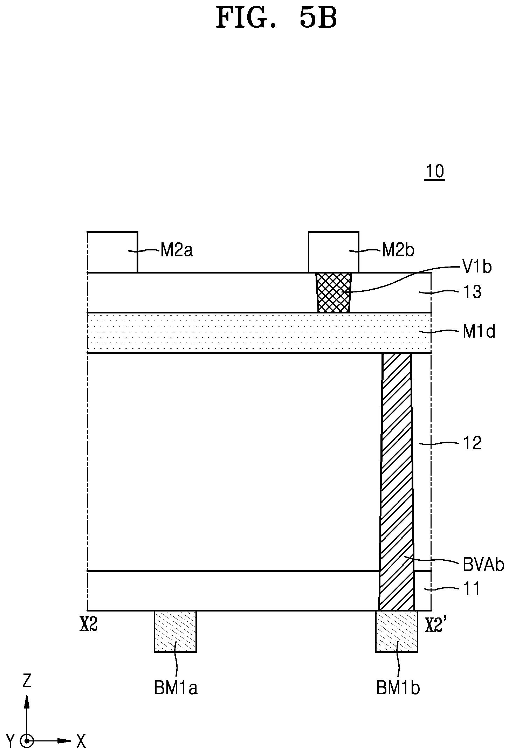

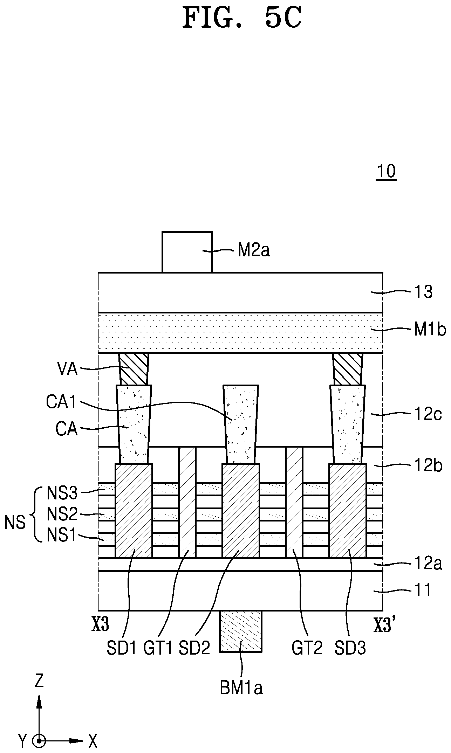

FIG. 5A is a cross-sectional view taken along line X1-X1' of FIG. 1 according to an embodiment, FIG. 5B is a cross-sectional view taken along line X2-X2' of FIG. 1 according to an embodiment, and FIG. 5C is a cross-sectional view taken along line X3-X3' of FIG. 1 according to an embodiment.

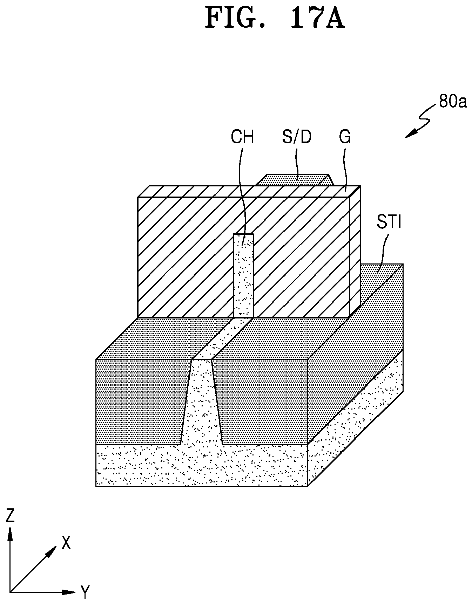

FIGS. 5A to 5C illustrate an example in which a nanosheet is formed on an active region. For example, a plurality of nanosheets may be stacked on the active region, and the gate lines may surround the plurality of nanosheets to form a multi-bridge channel (MBC) field effect transistor (FET) (MBCFET^{™}). However, the integrated circuit according to the disclosure is not limited to the description of FIGS 5A to 5C. For example, a FinFET including gate lines and fins formed on an active region may be formed. In another example, a gate-all-around (GAA) FET (GAAFET) in which nanowires formed on an active region are surrounded by gate lines may be formed. In another example, a vertical GAAFET in which a plurality of nanowires are vertically stacked on an active region and a plurality of nanowires are surrounded by gate lines may be formed. In another example, a negative capacitance (ND) FET may be formed in the active region. Moreover, various other transistors (a complementary FET (CFET), a negative FET (NCFET), a carbon nanotube FET (CNT), a bipolar junction transistor, etc.) may be formed in the active region. This will be described later in relation to FIGS. 17A to 17D.

Referring to FIGS. 1 and 5A to 5C, a first layer 11 may include a substrate or a semiconductor substrate and may be a p-type semiconductor substrate. For example, the semiconductor substrate may include at least one of silicon-on-insulator (SOI), silicon-on-sapphire, germanium, silicon-germanium, and gallium-arsenide. In FIGS. 5A and 5B, the first layer 11 or an upper portion of the first layer 11 may correspond to an element isolation layer such as a shallow trench isolation (STI). In FIG. 5C, the first layer 11 or the upper portion of the first layer 11 may correspond to, for example, an N well formed in a p-type substrate.

However, the disclosure is not limited thereto, and the first layer 11 may include an insulating layer. For example, during the manufacturing process of the integrated circuit 10, by forming the gate lines, the source/drain regions, the contacts, the vias, and/or the wiring layers on the front side of the substrate, a device wafer may be formed. Then, the device wafer may be temporarily bonded to a carrier wafer, and a back-grinding process may be performed on the device wafer. At least part of the substrate may be removed by the back-grinding process, and an insulating layer may be formed at a position of the removed part of the substrate. As such, a wafer on which the back-grinding process is performed such that the height of the substrate is less than or equal to a reference height may be referred to as a "bulkless wafer" or a "bulkless substrate."

A first interlayer insulating film 12 may be arranged on the first layer 11 in the vertical direction (Z), and the first interlayer insulating film 12 may include interlayer insulating films 12a, 12b, and 12c which are sequentially stacked. The first interlayer insulating film 12 may include an insulating material, and the insulating material may include, for example, at least one of an oxide film, a nitride film, and an oxynitride film. In the specification, a component that is arranged relatively in the vertical direction (Z) in comparison with other components (i.e., a component arranged in the Z-axis direction) may be described as being arranged on or above other components, and a component that is arranged relatively in an opposite direction of the vertical direction (Z) in comparison with other components (i.e., a component arranged in the -Z-axis direction) may be described as being arranged under or below the other components.

Referring to FIG. 5A, a backside via BVAa may extend in the vertical direction (Z) on the backside wiring pattern BM1a and may electrically connect the backside wiring pattern BM1a to the first frontside wiring pattern M1a. A second interlayer insulating film 13 may be arranged on the first frontside wiring pattern M1a. A second via V1a may extend in the vertical direction (Z) on the first frontside wiring pattern M1a and electrically connect the first frontside wiring pattern M1a to the second frontside wiring pattern M2a. For example, the first frontside wiring pattern M1a may receive the power voltage VDD from the backside wiring pattern BM1a and may also receive the power voltage VDD from the second frontside wiring pattern M2a.

Referring to FIG. 5B, a backside via BVAb may extend in the vertical direction (Z) on the backside wiring pattern BM1b and may electrically connect the backside wiring pattern BM1b to the first frontside wiring pattern M1d. The second interlayer insulating film 13 may be arranged on the first frontside wiring pattern M1d. A second via V1b may extend in the vertical direction (Z) on the first frontside wiring pattern M1d and electrically connect the first frontside wiring pattern M1d to the second frontside wiring pattern M2b. For example, the first frontside wiring pattern M1d may receive the ground voltage VSS from the backside wiring pattern BM1b and may also receive the ground voltage VSS from the second frontside wiring pattern M2b.

Referring to FIG. 5C, a nanosheet stack NS extending in the first direction (X) may be arranged on the interlayer insulating film 12a. The nanosheet stack NS may include a plurality of nanosheets which overlap in the vertical direction (Z) (for example, first to third nanosheets NS1 to NS3). For example, the nanosheet stack NS may be doped with an N-type impurity and form a P-type transistor. In an embodiment, the nanosheet stack NS may include Si, Ge, or SiGe. In an embodiment, the nanosheet stack NS may include InGaAs, InAs, GaSb, InSb, or a combination thereof.

Each of the first and second gate lines GT1 and GT2 may cover or at least partially cover the nanosheet stack NS and surround or at least partially surround each of the first to third nanosheets NS1 to NS3. Accordingly, the first to third nanosheets NS1 to NS3 may have a GAA structure. A gate insulating film may be arranged between the first to third nanosheets NS1 to NS3 and each of the first and second gate lines GT1 and GT2. The first and second gate lines GT1 and GT2 may include, for example, a metal material, such as tungsten (W), tantalum (Ta), etc., a silicide thereof, doped polysilicon, etc., and may be formed using, for example, a deposition process.

Source/drain regions SD1, SD2, and SD3 may include an epitaxial region of a semiconductor material. Each of the source/drain regions SD1 and SD3 may be connected to the first frontside wiring pattern M1b corresponding to the output node Y through a corresponding source/drain contact CA and first via VA. The source/drain region SD2 may be connected to the parallel power rails, the second frontside wiring pattern M2a, and the backside wiring pattern BM1a through the first source/drain contact CA1.

According to the embodiments described in relation to FIGS. 1 to 5C, by providing a power distribution network using the wiring layers arranged on the front side and/or the back side of the substrate (for example, the first and second frontside wiring layers M1 and M2 and the backside wiring layer BM1), the routing complexity may decrease, and the performance of the semiconductor device may be improved without an increase in area. More specifically, according to the embodiment, by connecting the parallel power rail to the source of the transistor, the source resistance may be reduced without causing an increase in area, which may lead to significant improvement in the performance of the semiconductor device.

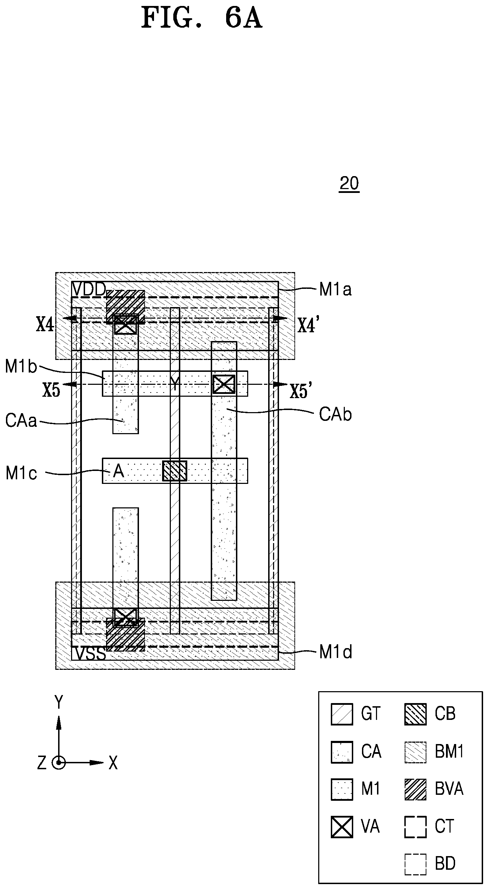

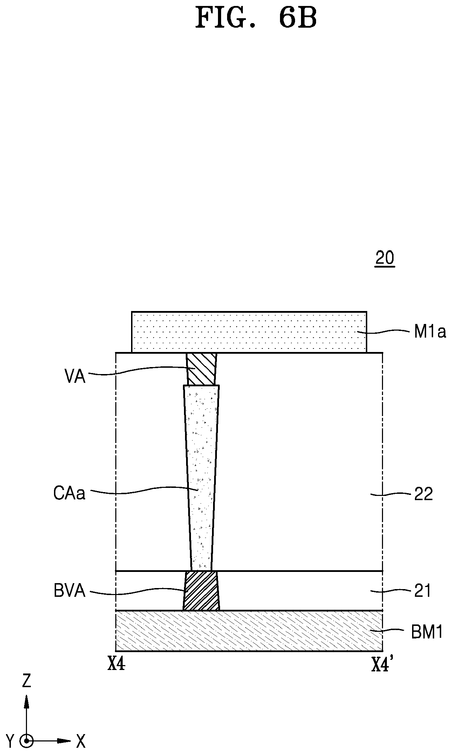

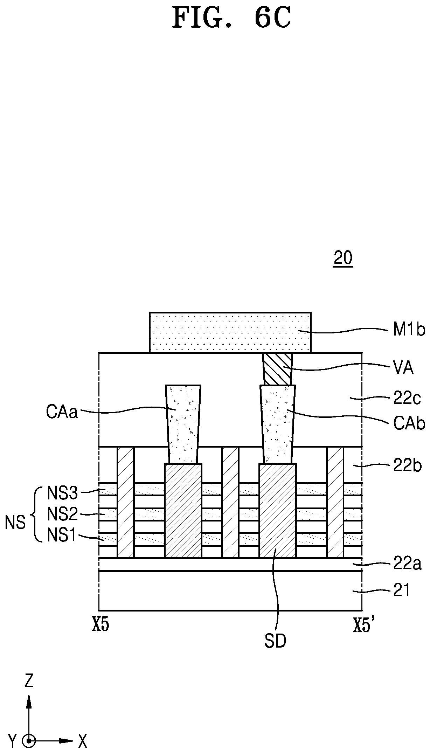

FIG. 6A is a diagram of an integrated circuit 20 according to an embodiment, FIG. 6B is a cross-sectional view taken along line X4-X4' of FIG. 6A according to an embodiment, and FIG. 6C is a cross-sectional view taken along line X5-X5' of FIG. 6A according to an embodiment. The integrated circuit 20 may be a modification of the integrated circuit 10 of FIG. 1, and the descriptions provided in relation to FIGS. 1 to 5C may be applied to the embodiment as well.

Referring to FIG. 6A, the integrated circuit 20 may include gate lines GT, source/drain contacts CA, a gate contact CB, a first frontside wiring layer M1, a first via VA, a backside wiring layer BM1, and a backside via BVA. The first frontside wiring layer M1 may include the first frontside wiring patterns M1a to M1d each extending in the first direction (X). The gate lines GT may each extend in the second direction (Y) and may be cut by a cutting layer CT. For example, the gate lines GT may be cut by the cutting layer CT overlapping the first frontside wiring pattern M1a and the cutting layer CT overlapping the first frontside wiring pattern M1d. The source/drain contacts CA may include a first source/drain contact CAa and a second source/drain contact CAb.

Referring to FIGS. 6B and 6C, a first layer 21 may be a substrate or a semiconductor substrate, and an interlayer insulating film 22 may be arranged on the first layer 21 in the vertical direction (Z). The backside wiring layer BM1 may be arranged under the first layer 21 in the vertical direction (Z) and extend in the first direction (X). The first frontside wiring pattern M1a may be arranged on the interlayer insulating film 22 and extend in the first direction (X). In the embodiment, the first source/drain contact CAa may be connected to the backside wiring layer BM1 through the backside via BVA and may be connected to the first frontside wiring pattern M1a through the first via VA.

The interlayer insulating film 22 may include interlayer insulating films 22a, 22b, and 22c. A nanosheet stack NS extending in the first direction (X) may be arranged on the interlayer insulating film 22a. A source/drain region SD may be electrically connected to the first frontside wiring pattern M1b through the second source/drain contact CAb and the first via VA.

For example, the first source/drain contact CAa may be connected to a source of a transistor, and the second source/drain contact CAb may be connected to a drain of a transistor. The first source/drain contact CAa may receive a supply voltage from the backside wiring layer BM1 and the first frontside wiring pattern M1a, and accordingly may implement a one-source parallel power rail structure. In an embodiment, a first frontside wiring pattern M1a may be connected to a second frontside wiring layer (for example, M2 of FIG. 1) arranged thereon and further receive a supply voltage from the second frontside wiring layer. Accordingly, the first source/drain contact CAa may be connected to the parallel power rail. Thus, the source resistance of the transistor may decrease, and the performance of the integrated circuit 20 may be improved without increasing the area of the integrated circuit 20.

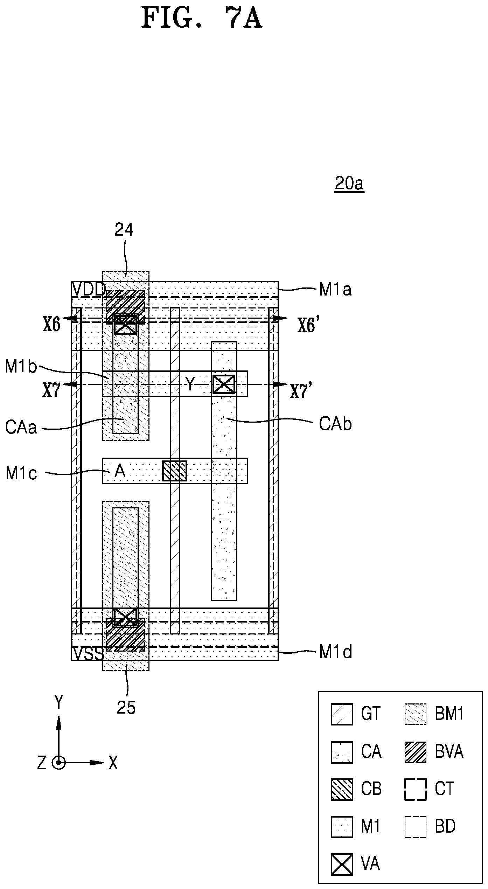

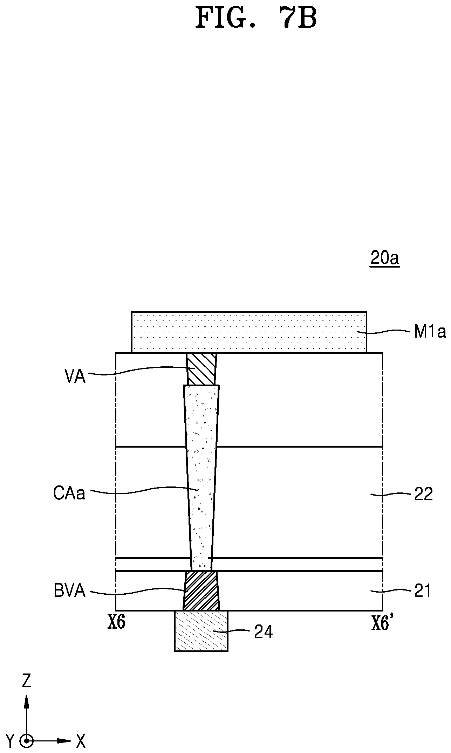

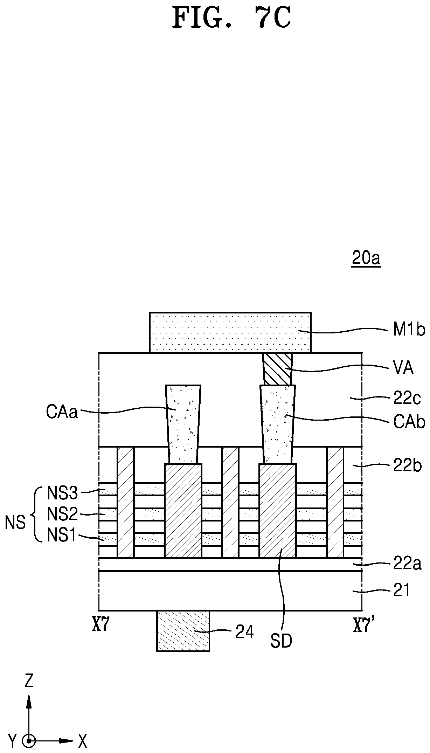

FIG. 7A is a layout of an integrated circuit 20a according to an embodiment, FIG. 7B is a cross-sectional view taken along line X6-X6' of FIG. 7A according to an embodiment, and FIG. 7C is a cross-sectional view taken along line X7-X7' of FIG. 7A according to an embodiment. The integrated circuit 20a may be a modification of the integrated circuit 20 of FIG. 6A, and the descriptions provided in relation to FIGS. 6A to 6C may be applied to the embodiment as well.

Referring to FIGS. 7A to 7C, the backside wiring layer BM1 of the integrated circuit 20a may include backside wiring patterns 24 and 25 each extending in the second direction (Y), and the backside wiring patterns 24 and 25 may be arranged in a line in the second direction (Y). For example, the power voltage VDD may be applied to the backside wiring pattern 24, and the ground voltage VSS may be applied to the backside wiring pattern 25.

The backside wiring pattern 24 may be arranged under the first layer 21 in the vertical direction (Z) and extend in the second direction (Y). The backside wiring pattern 24 may be electrically connected to the first frontside wiring pattern M1a through the backside via BVA, the first source/drain contact CAa, and the first via VA. Similarly, the backside wiring pattern 25 may be arranged under the first layer 21 in the vertical direction (Z) and extend in the second direction (Y).

In the embodiment, the first source/drain contact CAa may be connected to the backside wiring pattern 24 through the backside via BVA and may be connected to the first frontside wiring pattern M1a through the first via VA. The first source/drain contact CAa may receive a supply voltage from the backside wiring pattern 24 and the first frontside wiring pattern M1a, and accordingly may implement a one-source parallel power rail structure.

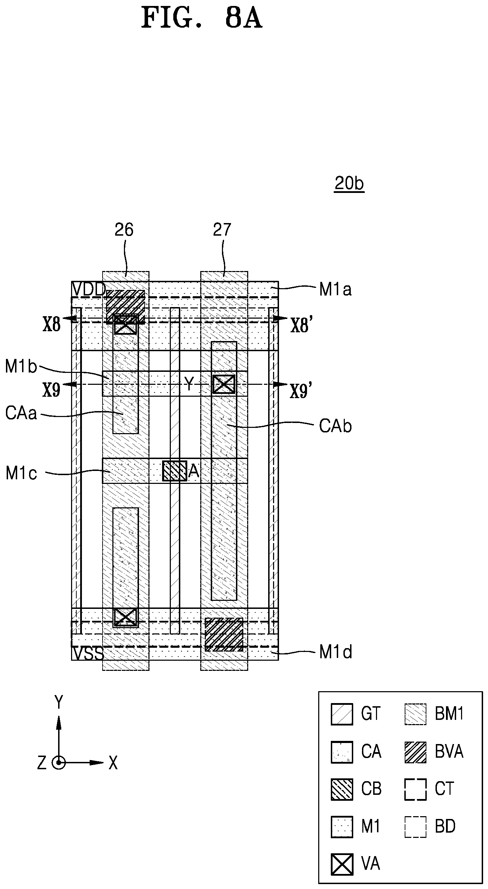

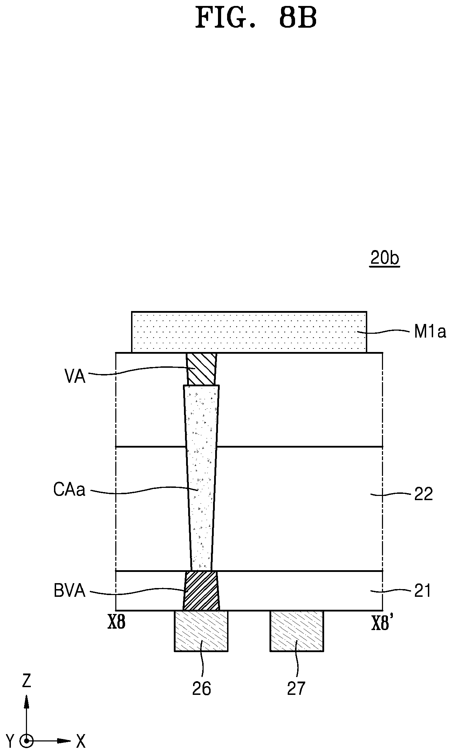

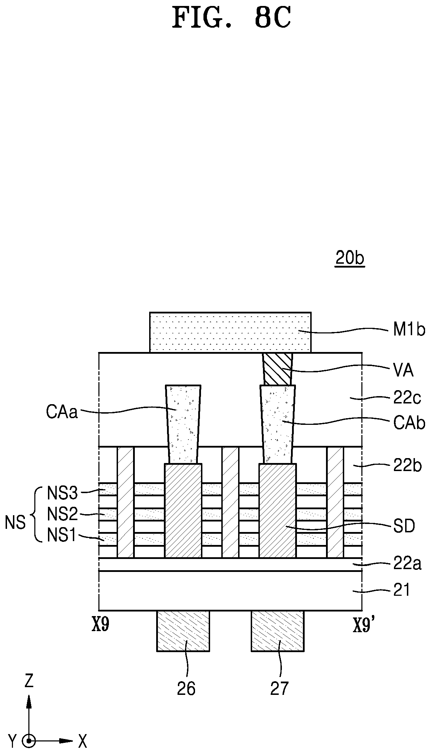

FIG. 8A is a layout of an integrated circuit 20b according to an embodiment, FIG. 8B is a cross-sectional view taken along line X8-X8' of FIG. 8A according to an embodiment, and FIG. 8C is a cross-sectional view taken along line X9-X9' of FIG. 8A according to an embodiment. The integrated circuit 20b may be a modification of the integrated circuit 20 of FIG. 6A, and the descriptions provided in relation to FIGS. 6A to 6C may be applied to the embodiment as well.

Referring to FIGS. 8A to 8C, the backside wiring layer BM1 of the integrated circuit 20b may include backside wiring patterns 26 and 27 each extending in the second direction (Y), and the backside wiring patterns 26 and 27 may be arranged apart from each other in the first direction (X). For example, the power voltage VDD may be applied to the backside wiring pattern 26, and the ground voltage VSS may be applied to the backside wiring pattern 27.

The backside wiring pattern 26 may be arranged under the first layer 21 in the vertical direction (Z) and extend in the second direction (Y). The backside wiring pattern 26 may be electrically connected to the first frontside wiring pattern M1a through the backside via BVA, the first source/drain contact CAa, and the first via VA. Similarly, the backside wiring pattern 27 may be arranged under the first layer 21 in the vertical direction (Z) and extend in the second direction (Y).

In the embodiment, the first source/drain contact CAa may be connected to the backside wiring pattern 26 through the backside via BVA and may be connected to the first frontside wiring pattern M1a through the first via VA. The first source/drain contact CAa may receive a supply voltage from the backside wiring pattern 26 and the first frontside wiring pattern M1a, and accordingly may implement a one-source parallel power rail structure.

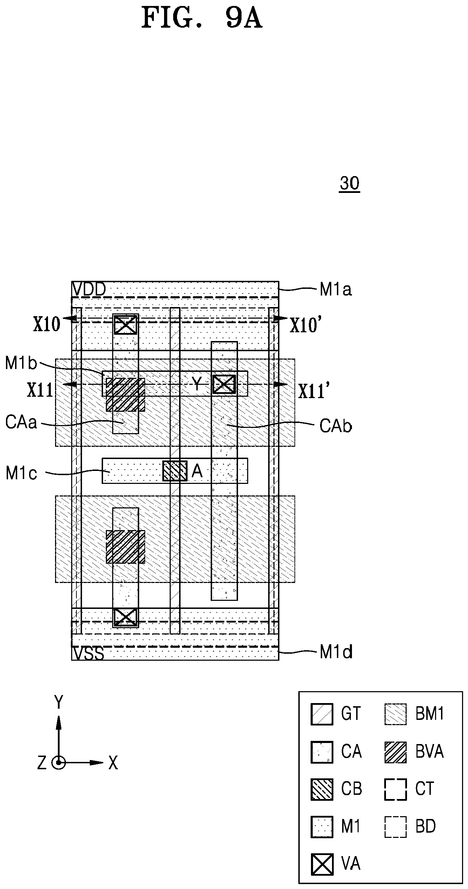

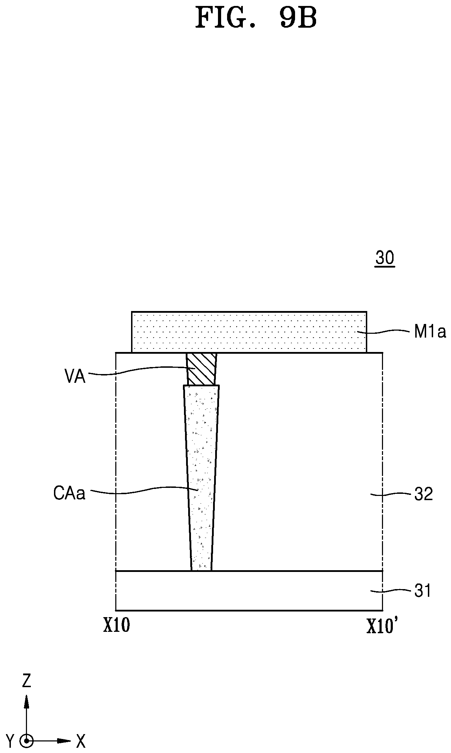

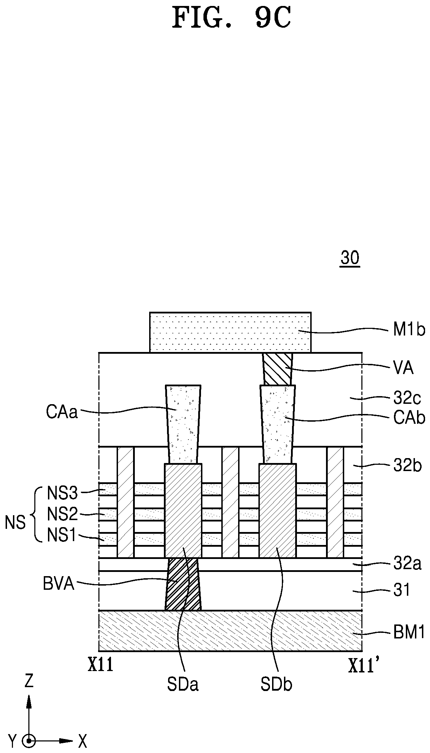

FIG. 9A is a layout of an integrated circuit 30 according to an embodiment, FIG. 9B is a cross-sectional view taken along line X10-X10' of FIG. 9A according to an embodiment, and FIG. 9C is a cross-sectional view taken along line X11-X11' of FIG. 9A according to an embodiment. The integrated circuit 30 may be a modification of the integrated circuit 10 of FIG. 1, and the descriptions provided in relation to FIGS. 1 to 5C may be applied to the embodiment as well.

Referring to FIG. 9A, the first frontside wiring layer M1 may include the first frontside wiring patterns M1a to M1d each extending in the first direction (X). The gate lines GT may each extend in the second direction (Y) and may be cut by the cutting layer CT. More specifically, the gate lines GT may be cut by the cutting layer CT overlapping the first frontside wiring pattern M1a and the cutting layer CT overlapping the first frontside wiring pattern M1d. The source/drain contacts CA may include a first source/drain contact CAa and a second source/drain contact CAb.

Referring to FIGS. 9B and 9C, a first layer 31 may be a semiconductor substrate, and an interlayer insulating film 32 may be arranged on the first layer 31 in the vertical direction (Z). The first source/drain contact CAa may extend in the vertical direction (Z) and may be electrically connected to the first frontside wiring pattern M1a through the first via VA. The interlayer insulating film 32 may include interlayer insulating films 32a, 32b, and 32c. A nanosheet stack NS extending in the first direction (X) may be arranged on the interlayer insulating film 32a.

The backside wiring layer BM1 (for example, a first backside wiring pattern in the backside wiring layer BM1) may be arranged under the first layer 31 in the vertical direction (Z) and extend in the first direction (X). The backside wiring layer BM1 may be electrically connected to a first source/drain region SDa through the backside via BVA. Such structure connecting a via or a contact to the bottom of an epitaxial region such as the first source/drain region SDa may be referred to as a "direct backside contact (DBC)." According to an embodiment, the DBC may include a backside contact and/or a backside via. A second source/drain region SDb may be electrically connected to the first frontside wiring pattern M1b through the second source/drain contact CAb and the first via VA. In an embodiment, the first source/drain region SDa may correspond to a source region in the integrated circuit 30, the second source/drain region SDb may correspond to a drain region in the integrated circuit 30, and the first source/drain region SDa and the second source/drain region SDb may be spaced apart in the first direction (X).

For example, the first source/drain contact CAa may be connected to a source region of a transistor, and the second source/drain contact CAb may be connected to a drain region of a transistor. The first source/drain contact CAa may receive the supply voltage from the first frontside wiring layer M1, and more specifically, from the first frontside wiring pattern M1a and the backside wiring layer BM1. Accordingly, a one-source parallel power rail structure may be implemented. The second source/drain contact CAb may be connected to the first frontside wiring layer M1, more specifically, to the first frontside wiring pattern M1b.

In an embodiment, the first source/drain region SDa (that is, the source region of the transistor) may be connected to the backside wiring layer BM1 through the DBC (for example, the backside via BVA), and the first source/drain contact CAa connected to the first source/drain region SDa may be connected to the first frontside wiring pattern M1a through the first via VA. Accordingly, the first source/drain region SDa may receive the supply voltage from the first frontside wiring pattern M1a and the backside wiring layer BM1, and accordingly, the first source/drain region SDa may be connected to the parallel power rail. Thus, the source resistance of the transistor may decrease, and the performance of the integrated circuit 30 may be improved without increasing the area of the integrated circuit 30.

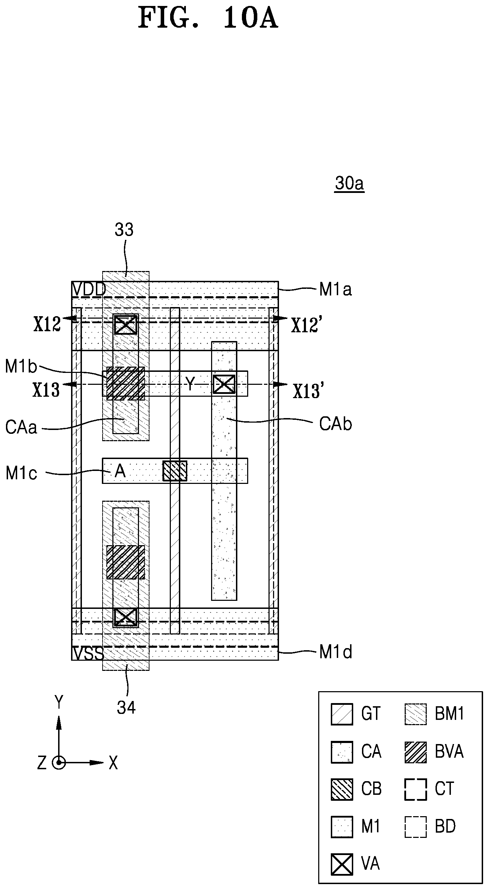

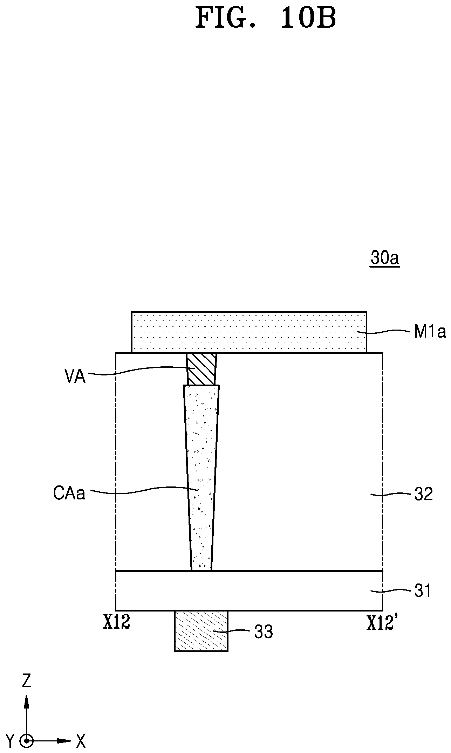

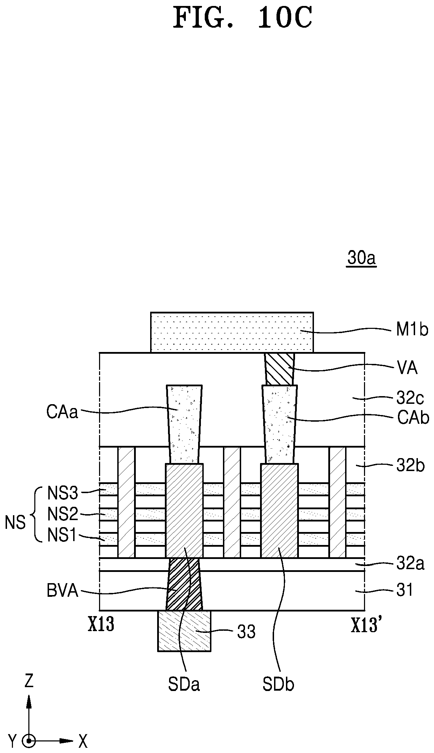

FIG. 10A is a layout of an integrated circuit 30a according to an embodiment, FIG. 10B is a cross-sectional view taken along line X12-X12' of FIG. 10A according to an embodiment, and FIG. 10C is a cross-sectional view taken along line X13-X13' of FIG. 10A according to an embodiment. The integrated circuit 30a may be a modification of the integrated circuit 30 of FIG. 9A, and the descriptions provided in relation to FIGS. 9A to 9C may be applied to the embodiment as well.

Referring to FIGS. 10A to 10C, the backside wiring layer BM1 of the integrated circuit 30a may include backside wiring patterns 33 and 34 each extending in the second direction (Y), and the backside wiring patterns 33 and 34 may be arranged in a line in the second direction (Y). For example, the power voltage VDD may be applied to the backside wiring pattern 33, and the ground voltage VSS may be applied to the backside wiring pattern 34.

The first source/drain contact CAa may extend in the vertical direction (Z) and may be electrically connected to the first frontside wiring pattern M1a through the first via VA. The backside wiring pattern 33 may be arranged under the first layer 31 in the vertical direction (Z) and extend in the second direction (Y). The backside wiring pattern 33 may be electrically connected to the first source/drain region SDa through the backside via BVA. The second source/drain region SDb may be electrically connected to the first frontside wiring pattern M1b through the second source/drain contact CAb and the first via VA.

In the embodiment, the first source/drain region SDa may be connected to the backside wiring pattern 33 through the backside via BVA, and the first source/drain contact CAa connected to the first source/drain region SDa may be connected to the first frontside wiring pattern M1a through the first via VA. Accordingly, the first source/drain region SDa may receive the supply voltage from the backside wiring pattern 33 and the first frontside wiring pattern M1a, and accordingly, the first source/drain region SDa may be connected to the parallel power rail. Thus, the source resistance of the transistor may decrease, and the performance of the integrated circuit 30a may be improved without increasing the area of the integrated circuit 30a.

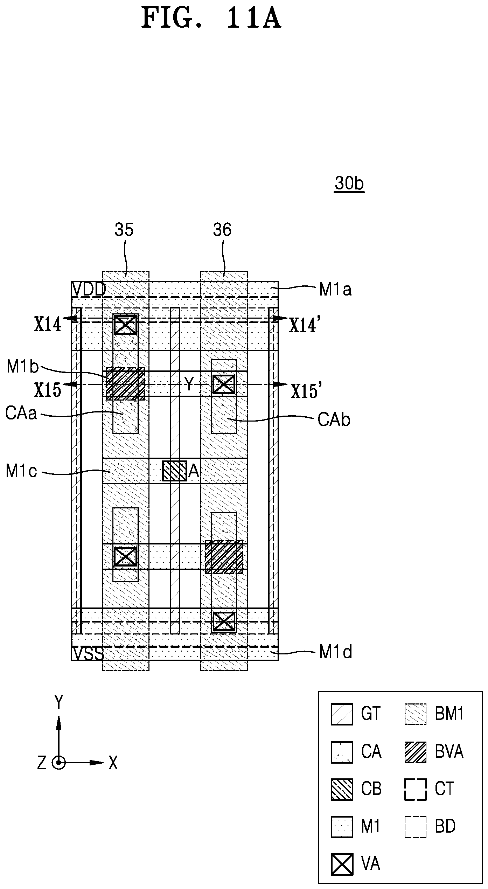

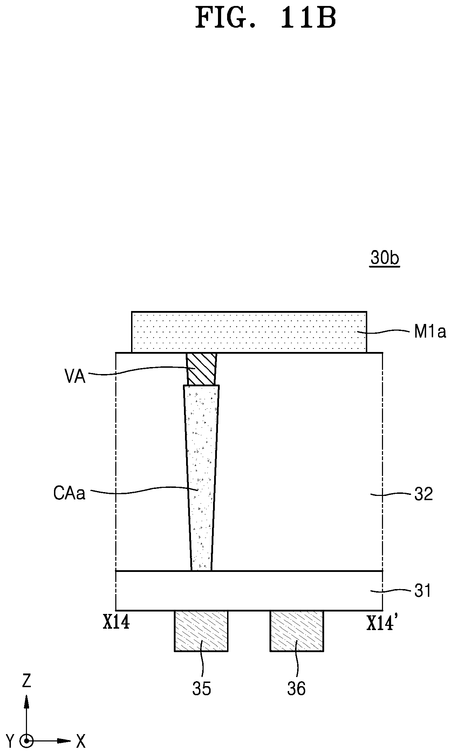

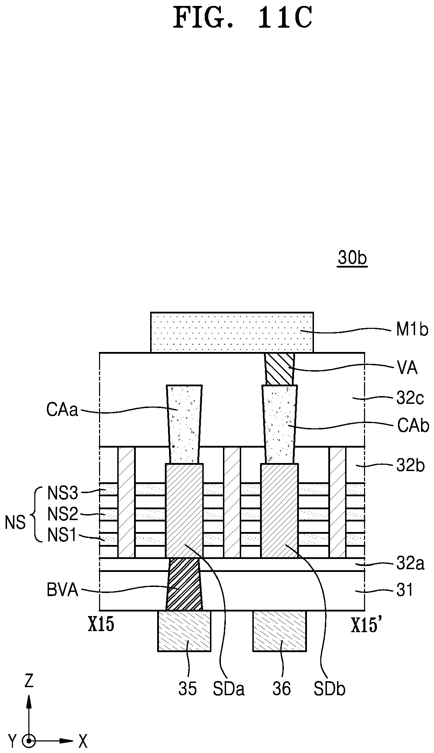

FIG. 11A is a layout of an integrated circuit 30b according to an embodiment, FIG. 11B is a cross-sectional view taken along line X14-X14' of FIG. 11A according to an embodiment, and FIG. 11C is a cross-sectional view taken along line X15-X15' of FIG. 11A according to an embodiment. The integrated circuit 30b may be a modification of the integrated circuit 30 of FIG. 9A, and the descriptions provided in relation to FIGS. 9A to 9C may be applied to the embodiment as well.

Referring to FIGS. 11A to 11C, the backside wiring layer BM1 of the integrated circuit 30b may include backside wiring patterns 35 and 36 each extending in the second direction (Y), and the backside wiring patterns 35 and 36 may be arranged apart from each other in the first direction (X). For example, the power voltage VDD may be applied to the backside wiring pattern 35, and the ground voltage VSS may be applied to the backside wiring pattern 36.

The first source/drain contact CAa may extend in the vertical direction (Z) and may be electrically connected to the first frontside wiring pattern M1a through the first via VA. The backside wiring pattern 35 may be arranged under the first layer 31 in the vertical direction (Z) and extend in the second direction (Y). The backside wiring pattern 35 may be electrically connected to the first source/drain region SDa through the backside via BVA. The second source/drain region SDb may be electrically connected to the first frontside wiring pattern M1b through the second source/drain contact CAb and the first via VA.

In the embodiment, the first source/drain region SDa may be connected to the backside wiring pattern 35 through the backside via BVA, and the first source/drain contact CAa connected to the first source/drain region SDa may be connected to the first frontside wiring pattern M1a through the first via VA. Accordingly, the first source/drain region SDa may receive the supply voltage from the backside wiring pattern 35 and the first frontside wiring pattern M1a, and accordingly, the first source/drain region SDa may be connected to the parallel power rail. Thus, the source resistance of the transistor may decrease, and the performance of the integrated circuit 30b may be improved without increasing the area of the integrated circuit 30b.

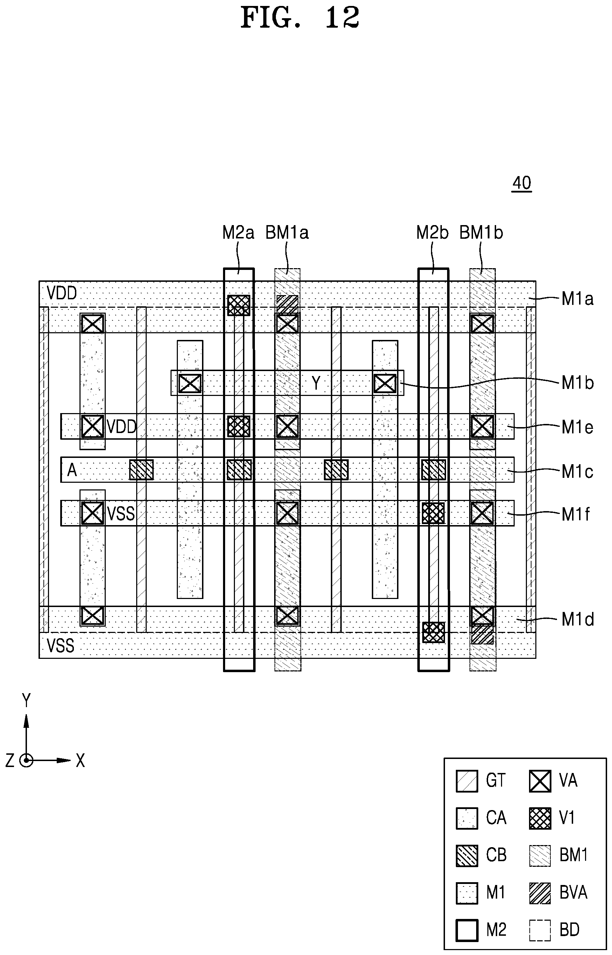

FIG. 12 is a diagram of an integrated circuit 40 according to an embodiment.

Referring to FIG. 12, the integrated circuit 40 may include gate lines GT, source/drain contacts CA, gate contacts CB, a first frontside wiring layer M1, a second frontside wiring layer M2, a first via VA, a second via V1, a backside wiring layer BM1, and a backside via BVA. For example, the gate lines GT, the source/drain contacts CA, and the gate contacts CB may constitute a standard cell, and the standard cell may be defined by a cell boundary BD. The integrated circuit 40 may be a modification of the integrated circuit 10 of FIG. 1, and the descriptions provided in relation to FIGS. 1 to 5C may be applied to the embodiment as well.

The first frontside wiring layer M1 may include first frontside wiring patterns M1a to M1f which each extend on the front side of the substrate in the first direction (X) and are arranged apart from each other in the second direction (Y). The first frontside wiring pattern M1c may receive a first control signal (for example, A), and the first frontside wiring pattern M1b may correspond to an output node (for example, Y). The first frontside wiring pattern M1c may be electrically connected to the gate lines GT through the gate contacts CB. The first frontside wiring pattern M1b may be electrically connected to some source/drain regions through the source/drain contacts CA.

The first frontside wiring patterns M1a and M1d may each overlap the cell boundary BD and may be referred to as "power rails." Hereinafter, the first frontside wiring pattern M1a is referred to as a first power rail M1a, and the first frontside wiring pattern M1d is referred to as a second power rail M1d. For example, the first power rail M1a may receive the power voltage VDD, and the second power rail M1d may receive the ground voltage VSS. However, the disclosure is not limited thereto. For example, the first power rail M1a may be electrically connected to the sources of the PMOS transistors by the source/drain contacts CA. For example, the second power rail M1d may be electrically connected to the sources of the NMOS transistors by the source/drain contacts CA.

The first frontside wiring patterns M1e and M1f may be arranged in the standard cell and may be referred to as "internal rails." Hereinafter, the first frontside wiring pattern M1e is referred to as a first internal rail M1e, and the first frontside wiring pattern M1f is referred to as a second internal rail M1f. For example, the first internal rail M1e may receive the power voltage VDD, and the second internal rail M1f may receive the ground voltage VSS. However, the disclosure is not limited thereto. For example, the first internal rail M1e may be electrically connected to the source/drain contacts CA connected to the PMOS transistor, through the first via VA, and the second internal rail M1f may be electrically connected to the source/drain contacts CA connected to the NMOS transistor, through the first via VA.

The second frontside wiring layer M2 may be arranged on the first frontside wiring layer M1 in the vertical direction (Z). The second frontside wiring layer M2 may include the second frontside wiring patterns M2a and M2b each extending in the second direction (Y). For example, the second frontside wiring pattern M2a may receive the power voltage VDD, and the second frontside wiring pattern M2b may receive the ground voltage VSS. For example, the second frontside wiring pattern M2a may be electrically connected to the first internal rail M1e through the second via V1 and also be connected to the first power rail M1a through the second via V1. For example, the second frontside wiring pattern M2b may be electrically connected to the second internal rail M1f through the second via V1 and also be connected to the second power rail M1d through the second via V1.

The backside wiring layer BM1 may be arranged on the back side of the substrate and may be arranged under the first frontside wiring layer M1 in the vertical direction (Z). The backside wiring layer BM1 may include the backside wiring patterns BM1a and BM1b each extending in the second direction (Y). For example, the backside wiring pattern BM1a may receive the power voltage VDD, and the backside wiring pattern BM1b may receive the ground voltage VSS. However, the disclosure is not limited thereto. For example, the backside wiring pattern BM1a may be electrically connected to the first power rail M1a through the backside via BVA. For example, the backside wiring pattern BM1b may be electrically connected to the second power rail M1d through the backside via BVA.

According to the embodiment, the source/drain contact CA connected to the source of the PMOS transistor may receive the power voltage VDD from the backside wiring pattern BM1a through the first via VA, the first power rail M1a, and the backside via BVA, receive the power voltage VDD from the second frontside wiring pattern M2a through the first via VA, the first power rail M1a, and the second via V1, and receive the power voltage VDD from the second frontside wiring pattern M2a through the first via VA, the first internal rail M1e, and the second via V1. As such, as the source of the PMOS transistor may receive the power voltage VDD from the backside wiring pattern BM1a and the second frontside wiring pattern M2a in parallel, the resistance of the source of the PMOS transistor may decrease, and the performance of the integrated circuit 40 may be improved.

In addition, according to the embodiment, the source/drain contact CA connected to the source of the NMOS transistor may receive the ground voltage VSS from the backside wiring pattern BM1b through the first via VA, the second power rail M1d, and the backside via BVA, receive the ground voltage VSS from the second frontside wiring pattern M2b through the first via VA, the second power rail M1d, and the second via V1, and receive the ground voltage VSS from the second frontside wiring pattern M2b through the first via VA, the second internal rail M1f, and the second via V1. As such, as the source of the NMOS transistor may receive the ground voltage VSS from the backside wiring pattern BM1b and the second frontside wiring pattern M2b in parallel, the resistance of the source of the NMOS transistor may decrease, and the performance of the integrated circuit 40 may be improved.

According to the above embodiment, as the first frontside wiring layer M1 further includes the first internal rail M1e, the parallel power rail providing the power voltage VDD may be connected to the source of the PMOS transistors, and as the first frontside wiring layer M1 further includes the second internal rail M1f, the parallel power rail providing the ground voltage VSS may be connected to the source of the NMOS transistors. However, the disclosure is not limited thereto, and in some embodiments, the first frontside wiring layer M1 may include only the first internal rail M1e, and in this case, the power voltage VDD may be supplied only to the source of the PMOS transistors without connecting the parallel power rail to the source of the NMOS transistors. In addition, in some embodiments, the first frontside wiring layer M1 include only the second internal rail M1f, and in this case, the ground voltage VSS may be supplied only to the source of the NMOS transistors without connecting the parallel power rail to the source of the PMOS transistors.

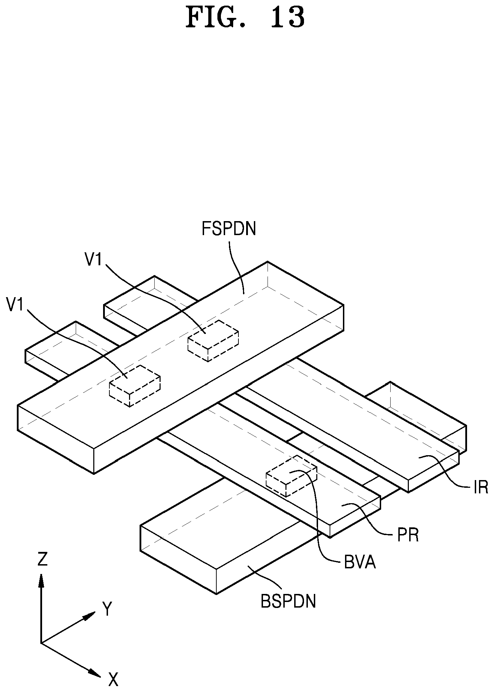

FIG. 13 is a perspective view of a PDN of FIG. 12 according to an embodiment.

Referring to FIG. 13, a power rail PR receiving a first voltage or a second voltage may extend in the first direction (X). For example, the power rail PR may be arranged to overlap the cell boundary (e.g., BD of FIG. 12) of the standard cell in the vertical direction (Z). The power rail PR may correspond to the first power rail M1a or the second power rail M1d of FIG. 12. In addition, an internal rail IR receiving a first voltage or a second voltage may extend in the first direction (X). For example, the internal rail IR may be arranged in the standard cell, and may be apart from the power rail PR in the second direction (Y). For example, the internal rail IR may correspond to the first internal rail M1e or the second internal rail M1f of FIG. 12.

The frontside wiring layer FSPDN may extend in the second direction (Y) on the internal rail IR and the power rail PR in the vertical direction (Z), may be electrically connected to the internal rail IR through the second via V1, and may be electrically connected to the power rail PR through the second via V1. For example, the frontside wiring layer FSPDN may correspond to the second frontside wiring pattern M2a or M2b of FIG. 12. However, the disclosure is not limited thereto, and the frontside wiring layer FSPDN may extend in the same direction as the extending direction of the power rail PR (for example, in the first direction (X)). In addition, in some embodiments, the frontside wiring layer FSPDN may be electrically connected to the internal rail IR through the second via V1 or may be electrically connected to the power rail PR through the second via V1.

A backside wiring layer BSPDN may extend in the second direction (Y) under the power rail PR in the vertical direction (Z) and may be electrically connected to the power rail PR through the backside via BVA. For example, the backside wiring layer BSPDN may correspond to the backside wiring pattern BM1a or BM1b of FIG. 12. However, the disclosure is not limited thereto, and the backside wiring layer BSPDN may extend in the same direction as the extending direction of the power rail PR (for example, in the first direction (X)).

In an embodiment, the frontside wiring layer FSPDN may not overlap the backside wiring layer BSPDN in the vertical direction (Z). However, the disclosure is not limited thereto, and in some embodiments, the frontside wiring layer FSPDN and the backside wiring layer BSPDN may at least partially overlap in the vertical direction (Z). As such, the arrangement and/or extending direction of the frontside wiring layer FSPDN and the backside wiring layer BSPDN may vary according to an embodiment.

According to the embodiment, the power rail PR and the internal rail IR may be arranged between the frontside wiring layer FSPDN and the backside wiring layer BSPDN. In an embodiment, the power rail PR may receive the supply voltage from the backside wiring layer BSPDN, and the internal rail IR may receive the supply voltage from the frontside wiring layer FSPDN. In an embodiment, the power rail PR may receive the supply voltage from the backside wiring layer BSPDN and the frontside wiring layer FSPDN, and the internal rail IR may receive the supply voltage from the frontside wiring layer FSPDN. In this case, the source of the transistor may be connected to the power rail PR and the internal rail IR to receive the supply voltage from the frontside wiring layer FSPDN and the backside wiring layer BSPDN, and accordingly, a parallel power rail may be implemented.

FIG. 13 illustrates that the power rail PR is connected to the backside wiring layer BSPDN, and the internal rail IR is connected to the frontside wiring layer FSPDN. However, the disclosure is not limited thereto. According to an embodiment, the power rail PR may be electrically connected to the frontside wiring layer FSPDN, and the internal rail IR may be electrically connected to the backside wiring layer BSPDN. Moreover, according to an embodiment, the power rail PR may be electrically connected to both of the backside wiring layer BSPDN and the frontside wiring layer FSPDN. In addition, according to an embodiment, the internal rail IR may be electrically connected to both of the frontside wiring layer FSPDN and the backside wiring layer BSPDN.

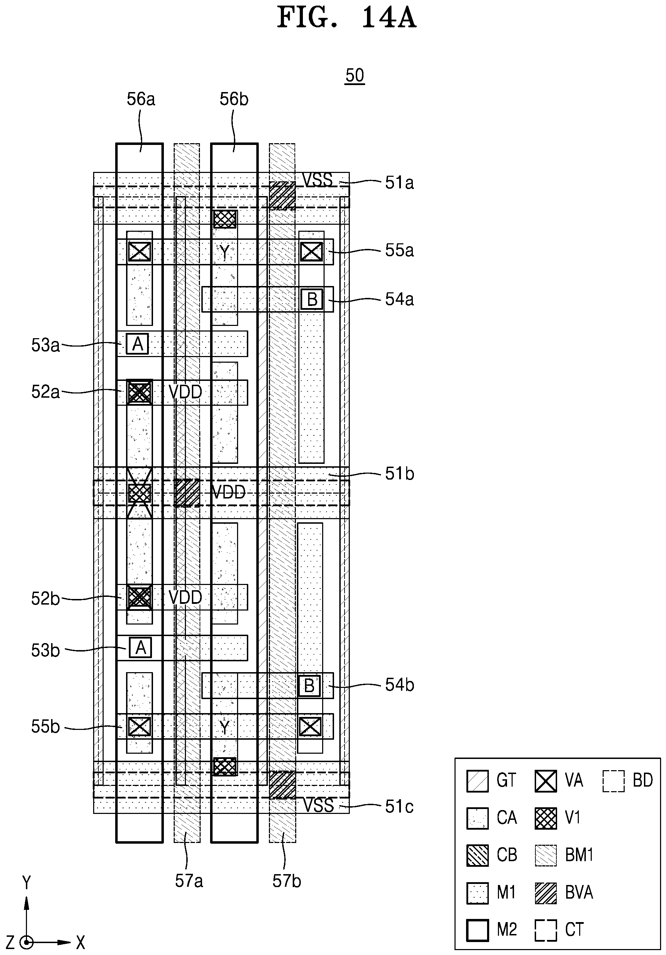

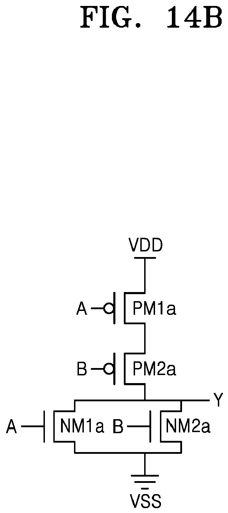

FIG. 14A is a diagram of an integrated circuit 50 according to an embodiment, and FIG. 14B is a circuit diagram corresponding to a part of FIG. 14A according to an embodiment.

Referring to FIGS. 14A and 14B, the integrated circuit 50 may include a first PMOS transistor PM1a, a second PMOS transistor PM2a, a first NMOS transistor NM1a, and a second NMOS transistor NM2a. The first and second PMOS transistors PM1a and PM2a may be connected in series, and the first and second NMOS transistors NM1a and NM2a may be connected in parallel. As such, the integrated circuit 50 may include a NOR gate cell.

The first PMOS transistor PM1a may include a source receiving the power voltage VDD and a gate receiving the first control signal A, and the second PMOS transistor PM2a may include a gate receiving a second control signal B and a drain connected to the output node Y. The first NMOS transistor NM1a may include a source receiving the ground voltage VSS, a gate receiving the first control signal A, and a drain connected to the output node Y, and the second NMOS transistor NM2a may include a source receiving the ground voltage VSS, a gate receiving the second control signal B, and a drain connected to the output node Y.

In the NOR gate cell, as the first and second PMOS transistors PM1a and PM2a have a stacked structure, the operation speed may decrease. According to an embodiment, by connecting the parallel power rail to the source of the first PMOS transistor PM1a, the source resistance of the first PMOS transistor PM1a may decrease. Hereinafter, the layout in which the parallel power rail is connected to the source of the first PMOS transistor PM1a is described.

The integrated circuit 50 may be designed in a layout including gate lines GT, source/drain contacts CA, gate contacts CB, a first frontside wiring layer M1, a second frontside wiring layer M2, a first via VA, a second via V1, a backside wiring layer BM1, and a backside via BVA. For example, the gate lines GT, the source/drain contacts CA, and the gate contacts CB may constitute a standard cell, and the standard cell may be defined by a cell boundary BD. For example, the integrated circuit 50 may include two standard cells.

The first frontside wiring layer M1 may include a first power rail 51a, a second power rail 51b, a third power rail 51c, a first internal rail 52a, a second internal rail 52b, first input wiring patterns 53a and 53b, second input wiring patterns 54a and 54b, and output wiring patterns 55a and 55b. The second frontside wiring layer M2 may include frontside wiring patterns 56a and 56b arranged on the first frontside wiring layer M1 in the vertical direction (Z). The backside wiring layer BM1 may include backside wiring patterns 57a and 57b arranged on the back side of the substrate.

The first power rail 51a may receive the ground voltage VSS, the second power rail 51b may receive the power voltage VDD, and the third power rail 51c may receive the ground voltage VSS. For example, the first power rail 51a may receive the ground voltage VSS from the backside wiring pattern 57b through the backside via BVA, and receive the ground voltage VSS from the frontside wiring pattern 56b through the second via V1. For example, the second power rail 51b may receive the power voltage VDD from the backside wiring pattern 57a through the backside via BVA, and receive the power voltage VDD from the frontside wiring pattern 56a through the second via V1. For example, the third power rail 51c may receive the ground voltage VSS from the backside wiring pattern 57b through the backside via BVA, and receive the ground voltage VSS from the frontside wiring pattern 56b through the second via V1. For example, the first, second and third power rails 51a, 51b, and 51c may be implemented as the power rail PR illustrated in FIG. 3.

The first and second internal rails 52a and 52b may receive the power voltage VDD. For example, the first and second internal rails 52a and 52b may receive the power voltage VDD from the frontside wiring pattern 56a through the second via V1. The first internal rail 52a may be electrically connected to the source/drain contact CA connected to the source of the first PMOS transistor PM1a, through the first via VA. In addition, the second internal rail 52b may be electrically connected to the source/drain contact CA connected to the source of the first PMOS transistor PM1a, through the first via VA.

The first input wiring patterns 53a and 53b may receive a first control signal (e.g., A), and the second input wiring patterns 54a and 54b may receive a second control signal (e.g., B). The first and second input wiring patterns 53a, 53b, 54a, and 54b may be electrically connected to the gate lines GT through the gate contacts CB. The output wiring patterns 55a and 55b may correspond to an output node (e.g., Y). The output wiring patterns 55a and 55b may be electrically connected to the drains of the transistors through the source/drain contacts CA.

According to the embodiment, the source/drain contact CA connected to the source of the first PMOS transistor PM1a may receive the power voltage VDD from the backside wiring pattern 57a through the first via VA, the second power rail 51b, and the backside via BVA and receive the power voltage VDD from the frontside wiring pattern 56a through the first via VA, the second power rail 51b, and the second via V1. As such, as the source of the first PMOS transistor PM1a may receive the power voltage VDD from the backside wiring pattern 57a and the frontside wiring pattern 56a in parallel, the resistance of the source of the first PMOS transistor PM1a may decrease, and the performance of the integrated circuit 50 may be improved.

In addition, according to the embodiment, as the integrated circuit 50 includes the first and second internal rails 52a and 52b receiving the power voltage VDD, the source/drain contact CA connected to the source of the first PMOS transistor PM1a of the first standard cell may further receive the power voltage VDD from the frontside wiring pattern 56a through the first via VA, the first internal rail 52a, and the second via V1, and the source/drain contact CA connected to the source of the first PMOS transistor PM1a of the second standard cell may further receive the power voltage VDD from the frontside wiring pattern 56a through the first via VA, the second internal rail 52b, and the second via V1. As such, as the source of the first PMOS transistor PM1a may variously receive the parallel power voltage VDD from the backside wiring pattern 57a and the frontside wiring pattern 56a, the resistance of the source of the first PMOS transistor PM1a may further decrease, and the performance of the integrated circuit 50 may be improved even more.

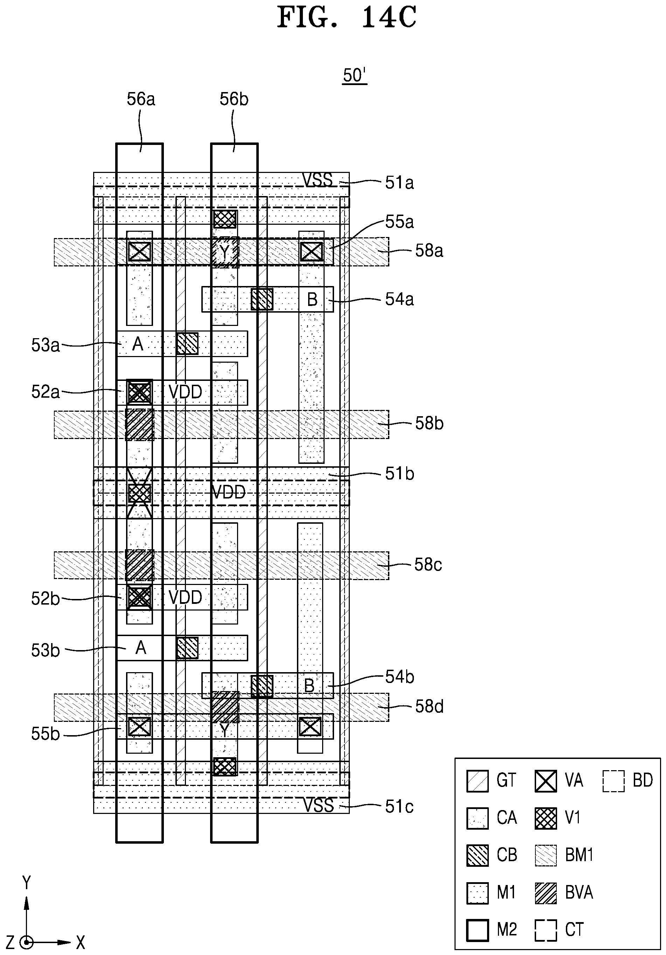

FIG. 14C is a layout of an integrated circuit 50' corresponding to FIG. 14B according to an embodiment.

Referring to FIG. 14C, the integrated circuit 50' may be a modification of the integrated circuit 50 of FIG. 14A and may be arranged and wired according to the circuit diagram of FIG. 14B. Accordingly, the descriptions made with reference to FIGS. 14A and 14B may be applied to this embodiment as well. The integrated circuit 50' may be designed in a layout including gate lines GT, source/drain contacts CA, gate contacts CB, a first frontside wiring layer M1, a second frontside wiring layer M2, a first via VA, a second via V1, a backside wiring layer BM1, and a backside via BVA.

The first power rail 51a may receive the ground voltage VSS, the second power rail 51b may receive the power voltage VDD, and the third power rail 51c may receive the ground voltage VSS. For example, the first power rail 51a may receive the ground voltage VSS from the frontside wiring pattern 56b through the second via V1. For example, the second power rail 51b may receive the power voltage VDD from the frontside wiring pattern 56a through the second via V1. For example, the third power rail 51c may receive the ground voltage VSS from the frontside wiring pattern 56b through the second via V1.

In an embodiment, the backside wiring layer BM1 may include backside wiring patterns 58a to 58d arranged on the back side of the substrate. The backside wiring patterns 58a to 58d may each extend in the first direction (X) and may be arranged apart from each other in the second direction (Y). For example, the backside wiring patterns 58a and 58d may receive the ground voltage VSS and the backside wiring patterns 58b and 58c may receive the power voltage VDD. In this regard, the backside wiring patterns 58a to 58d may each be electrically connected to the source/drain regions through corresponding backside vias BVA. Accordingly, the backside via BVA may be used as a DBC, and the integrated circuit 50' may be designed to have a DBC structure.

In an embodiment, the source of the first PMOS transistor PM1a may receive the power voltage VDD from the backside wiring pattern 58c through the backside via BVA, and the source/drain contact CA connected to the source of the first PMOS transistor PM1a may receive the power voltage VDD from the frontside wiring pattern 56a through the first via VA, the second power rail 5 1b, and the second via V1. As such, as the source of the first PMOS transistor PM1a may receive the power voltage VDD from the backside wiring pattern 58c and the frontside wiring pattern 56a in parallel, the resistance of the source of the first PMOS transistor PM1a may decrease, and the performance of the integrated circuit 50' may be improved.

In some embodiments, the backside wiring layer BM1 may further include a backside wiring pattern electrically connected to the first power rail 51a and transmitting the ground voltage VSS to the first power rail 51a, a backside wiring pattern electrically connected to the second power rail 51b and transmitting the power voltage VDD to the second power rail 51b, and/or a backside wiring pattern electrically connected to the third power rail 51c and transmitting the ground voltage VSS to the third power rail 51c.

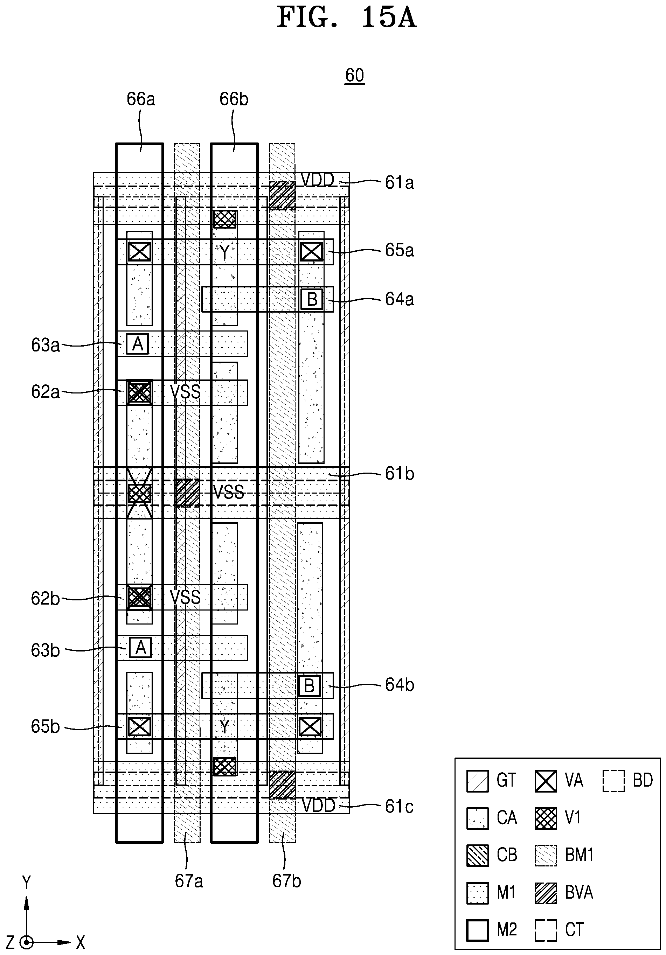

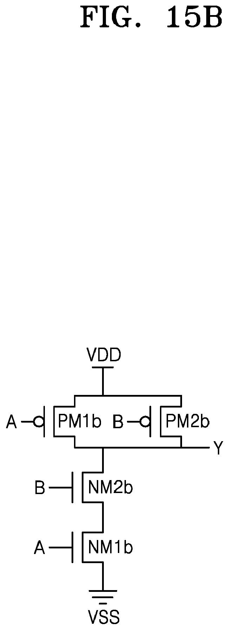

FIG. 15A is a layout of an integrated circuit 60 according to an embodiment, and FIG. 15B is a circuit diagram corresponding to a part of FIG. 15A according to an embodiment.

Referring to FIGS. 15A and 15B, the integrated circuit 60 may include a first PMOS transistor PM1b, a second PMOS transistor PM2b, a first NMOS transistor NM1b, and a second NMOS transistor NM2b. The first and second PMOS transistors PM1b and PM2b may be connected in parallel, and the first and second NMOS transistors NM1b and NM2b may be connected in series. As such, the integrated circuit 60 may include a NAND gate cell.

The first PMOS transistor PM1b may include a source receiving the power voltage VDD, a gate receiving the first control signal A, and a drain connected to the output node Y, and the second PMOS transistor PM2b may include a source receiving the power voltage VDD, a gate receiving the second control signal B, and a drain connected to the output node Y. The first NMOS transistor NM1b may include a source receiving the ground voltage VSS and a gate receiving the first control signal A, and the second NMOS transistor NM2b may include a gate receiving the second control signal B and a drain connected to the output node Y.

In such NAND gate cell, as the first and second NMOS transistors NM1b and NM2b have a stacked structure, the operation speed may decrease. According to an embodiment, by connecting the parallel power rail to the source of the first NMOS transistor NM1b, the source resistance of the first NMOS transistor NM1b may decrease. Hereinafter, the layout in which the parallel power rail is connected to the source of the first NMOS transistor NM1b is described.

The integrated circuit 60 may be designed in a layout including gate lines GT, source/drain contacts CA, gate contacts CB, a first frontside wiring layer M1, a second frontside wiring layer M2, a first via VA, a second via V1, a backside wiring layer BM1, and a backside via BVA. For example, the gate lines GT, the source/drain contacts CA, and the gate contacts CB may constitute a standard cell, and the standard cell may be defined by a cell boundary BD. For example, the integrated circuit 60 may include two standard cells.

The first frontside wiring layer M1 may include a first power rail 61a, a second power rail 61b, a third power rail 61c, a first internal rail 62a, a second internal rail 62b, first input wiring patterns 63a and 63b, second input wiring patterns 64a and 64b, and output wiring patterns 65a and 65b. The second frontside wiring layer M2 may include frontside wiring patterns 66a and 66b arranged on the first frontside wiring layer M1 in the vertical direction (Z). The backside wiring layer BM1 may include backside wiring patterns 67a and 67b arranged on the back side of the substrate.

The first power rail 61a may receive the power voltage VDD, the second power rail 61b may receive the ground voltage VSS, and the third power rail 61c may receive the power voltage VDD. For example, the first power rail 61a may receive the power voltage VDD from the backside wiring pattern 67b through the backside via BVA, and receive the power voltage VDD from the frontside wiring pattern 66b through the second via V1. For example, the second power rail 61b may receive the ground voltage VSS from the backside wiring pattern 67a through the backside via BVA, and receive the ground voltage VSS from the frontside wiring pattern 66a through the second via V1. For example, the third power rail 61c may receive the power voltage VDD from the backside wiring pattern 67b through the backside via BVA, and receive the power voltage VDD from the frontside wiring pattern 66b through the second via V1. For example, the first, second and third power rails 61a, 61b, and 61c may be implemented as the power rail PR illustrated in FIG. 3.

The first and second internal rails 62a and 62b may receive the ground voltage VSS. For example, the first and second internal rails 62a and 62b may receive the ground voltage VSS from the frontside wiring pattern 66a through the second via V1. The first internal rail 62a may be electrically connected to the source/drain contact CA connected to the source of the first NMOS transistor NM1b, through the first via VA. In addition, the second internal rail 62b may be electrically connected to the source/drain contact CA connected to the source of the first NMOS transistor NM1b, through the first via VA.

The first input wiring patterns 63a and 63b may receive a first control signal (e.g., A), and the second input wiring patterns 64a and 64b may receive a second control signal (e.g., B). The first and second input wiring patterns 63a, 63b, 64a, and 64b may be electrically connected to the gate lines GT through the gate contacts CB. The output wiring patterns 65a and 65b may correspond to an output node (e.g., Y). The output wiring patterns 65a and 65b may be electrically connected to the drains of the transistors through the source/drain contacts CA.

According to the embodiment, the source/drain contact CA connected to the source of the first NMOS transistor NM1b may receive the ground voltage VSS from the backside wiring pattern 67a through the first via VA, the second power rail 61b, and the backside via BVA and receive the ground voltage VSS from the frontside wiring pattern 66a through the first via VA, the second power rail 61b, and the second via V1. As such, as the source of the first NMOS transistor NM1b may receive the ground voltage VSS from the backside wiring pattern 67a and the frontside wiring pattern 66a in parallel, the resistance of the source of the first NMOS transistor NM1b may decrease, and the performance of the integrated circuit 60 may be improved.

In addition, according to the embodiment, as the integrated circuit 60 includes the first and second internal rails 62a and 62b receiving the ground voltage VSS, the source/drain contact CA connected to the source of the first NMOS transistor NM1b of the first standard cell may further receive the ground voltage VSS from the frontside wiring pattern 66a through the first via VA, the first internal rail 62a, and the second via V1, and the source/drain contact CA connected to the source of the first NMOS transistor NM1b of the second standard cell may further receive the ground voltage VSS from the frontside wiring pattern 66a through the first via VA, the second internal rail 62b, and the second via V1. As such, as the source of the first NMOS transistor NM1b may variously receive the parallel ground voltage VSS from the backside wiring pattern 67a and the frontside wiring pattern 66a, the resistance of the source of the first NMOS transistor NM1b may further decrease, and the performance of the integrated circuit 60 may be improved even more.

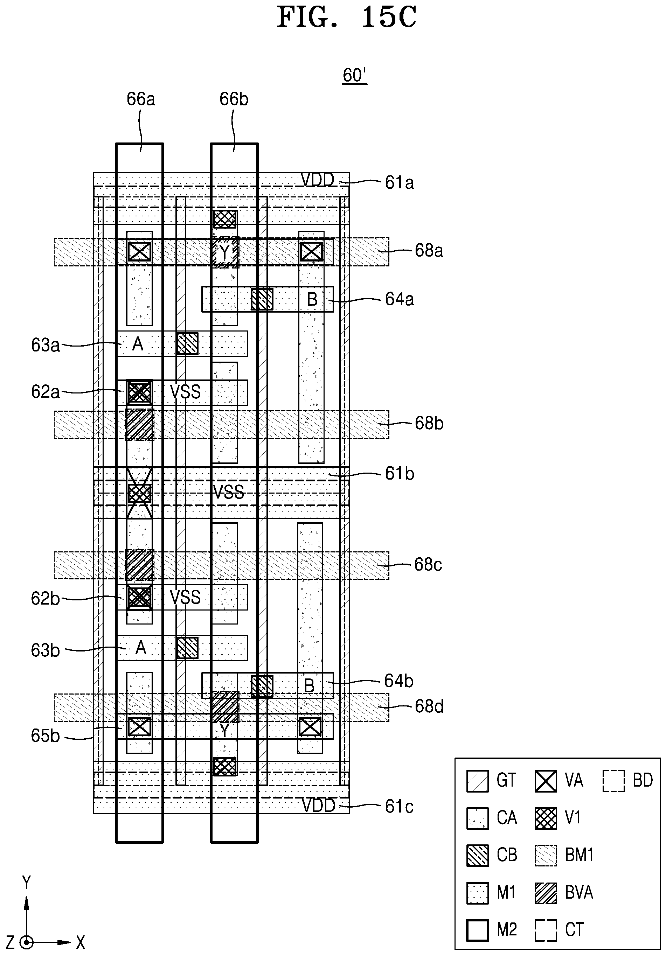

FIG. 15C is a layout of an integrated circuit 60' corresponding to FIG. 15B according to an embodiment.

Referring to FIG. 15C, the integrated circuit 60' may be a modification of the integrated circuit 60 of FIG. 15A and may be arranged and wired according to the circuit diagram of FIG. 15B. Accordingly, the descriptions made with reference to FIGS. 15A and 15B may be applied to this embodiment as well. The integrated circuit 60' may be designed in a layout including gate lines GT, source/drain contacts CA, gate contacts CB, a first frontside wiring layer M1, a second frontside wiring layer M2, a first via VA, a second via V1, a backside wiring layer BM1, and a backside via BVA.

The first power rail 61a may receive the power voltage VDD, the second power rail 61b may receive the ground voltage VSS, and the third power rail 61c may receive the power voltage VDD. For example, the first power rail 61a may receive the power voltage VDD from the frontside wiring pattern 66b through the second via V1. For example, the second power rail 61b may receive the ground voltage VSS from the frontside wiring pattern 66a through the second via V1. For example, the third power rail 61c may receive the power voltage VDD from the frontside wiring pattern 66b through the second via V1.

In an embodiment, the backside wiring layer BM1 may include backside wiring patterns 68a to 68d arranged on the back side of the substrate. The backside wiring patterns 68a to 68d may each extend in the first direction (X) and may be arranged apart from each other in the second direction (Y). For example, the backside wiring patterns 68a and 68d may receive the power voltage VDD and the backside wiring patterns 68b and 68c may receive the ground voltage VSS. In this regard, the backside wiring patterns 68a to 68d may each be electrically connected to the source/drain regions through corresponding backside vias BVA. Accordingly, the backside via BVA may be used as a DBC, and the integrated circuit 60' may be designed to have a DBC structure.

The source of the first NMOS transistor NM1b may receive the ground voltage VSS from the backside wiring pattern 68c through the backside via BVA, and the source/drain contact CA connected to the source of the first NMOS transistor NM1b may receive the ground voltage VSS from the frontside wiring pattern 66a through the first via VA, the second power rail 61b, and the second via V1. As such, as the source of the first NMOS transistor NM1b may receive the ground voltage VSS from the backside wiring pattern 68c and the frontside wiring pattern 66a in parallel, the resistance of the source of the first NMOS transistor NM1b may decrease, and the performance of the integrated circuit 60' may be improved.

In some embodiments, the backside wiring layer BM1 may further include a backside wiring pattern electrically connected to the first power rail 61a and transmitting the power voltage VDD to the first power rail 61a, a backside wiring pattern electrically connected to the second power rail 61b and transmitting the ground voltage VSS to the second power rail 61b, and/or a backside wiring pattern electrically connected to the third power rail 61c and transmitting the power voltage VDD to the third power rail 61c.

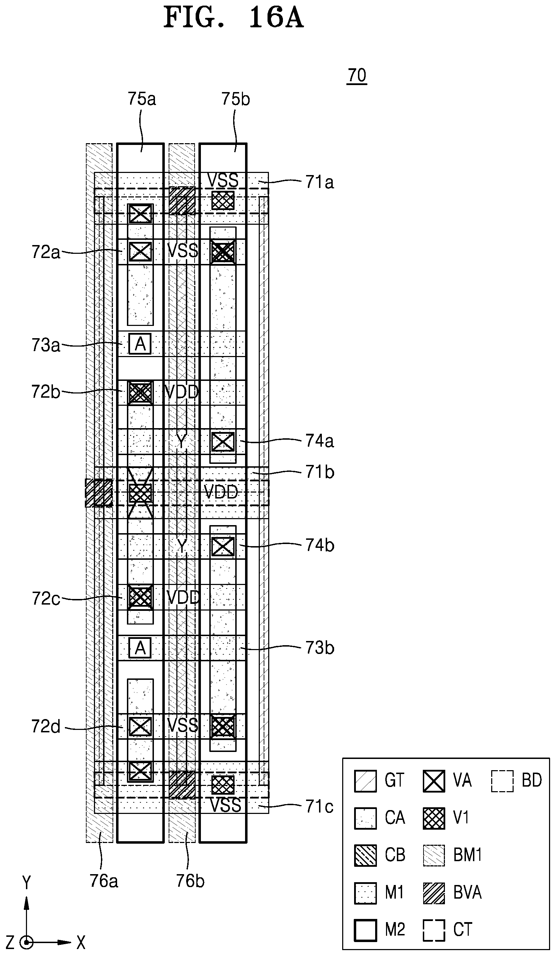

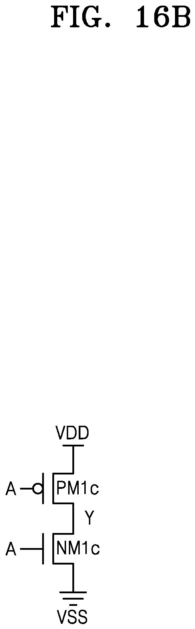

FIG. 16A is a diagram of an integrated circuit 70 according to an embodiment, and FIG. 16B is a circuit diagram corresponding to a part of FIG. 16A according to an embodiment.

Referring to FIGS. 16A and 16B, the integrated circuit 70 may include PMOS transistors PM1c and NMOS transistors NM1c, which are connected in series. As such, the integrated circuit 70 may include an inverter cell. The PMOS transistor PM1c may include a source receiving the power voltage VDD, a gate receiving the first control signal A, and a drain connected to the output node Y. The NMOS transistor NMIc may include a source receiving the ground voltage VSS, a gate receiving the first control signal A, and a drain connected to the output node Y. According to an embodiment, by connecting the parallel power rail to each of the PMOS transistor PM1c and the NMOS transistor NM1c, the source resistance of the PMOS transistor PM1c and the source resistance of the NMOS transistor NM1c may be reduced. Hereinafter, the layout in which the parallel power rail is connected to the source of the PMOS transistor PM1c and the source of the NMOS transistor NM1c is described.

The integrated circuit 70 may be designed in a layout including gate lines GT, source/drain contacts CA, gate contacts CB, a first frontside wiring layer M1, a second frontside wiring layer M2, a first via VA, a second via V1, a backside wiring layer BM1, and a backside via BVA. For example, the gate lines GT, the source/drain contacts CA, and the gate contacts CB may constitute a standard cell, and the standard cell may be defined by a cell boundary BD. For example, the integrated circuit 70 may include two standard cells.

The first frontside wiring layer M1 may include a first power rail 71a, a second power rail 71b, a third power rail 71c, a first internal rail 72a, a second internal rail 72b, a third internal rail 72c, a fourth internal rail 72d, input wiring patterns 73a and 73b, and output wiring patterns 74a and 74b. The second frontside wiring layer M2 may include frontside wiring patterns 75a and 75b arranged on the first frontside wiring layer M1 in the vertical direction (Z). The backside wiring layer BM1 may include backside wiring patterns 76a and 76b arranged on the back side of the substrate.

The first power rail 71a may receive the ground voltage VSS, the second power rail 71b may receive the power voltage VDD, and the third power rail 71c may receive the ground voltage VSS. For example, the first power rail 71a may receive the ground voltage VSS from the backside wiring pattern 76b through the backside via BVA, and receive the ground voltage VSS from the frontside wiring pattern 75b through the second via V1. For example, the second power rail 71b may receive the power voltage VDD from the backside wiring pattern 76a through the backside via BVA, and receive the power voltage VDD from the frontside wiring pattern 75a through the second via V1. For example, the third power rail 71c may receive the ground voltage VSS from the backside wiring pattern 76b through the backside via BVA, and receive the ground voltage VSS from the frontside wiring pattern 75b through the second via V1. For example, the first, second and third power rails 71a, 71b, and 71c may be implemented as the power rail PR illustrated in FIG. 3.

The first and fourth internal rails 72a and 72d may receive the ground voltage VSS. For example, the first and fourth internal rails 72a and 72d may receive the ground voltage VSS from the frontside wiring pattern 75b through the second via V1. The first and fourth internal rails 72a and 72d may be electrically connected to the source/drain contact CA connected to the source of the NMOS transistor NM1c, through the first via VA.

The second and third internal rails 72b and 72c may receive the power voltage VDD. For example, the second and third internal rails 72b and 72c may receive the power voltage VDD from the frontside wiring pattern 75a through the second via V1. The second and third internal rails 72b and 72c may be electrically connected to the source/drain contact CA connected to the source of the PMOS transistor PM1c, through the first via VA.

The input wiring patterns 73a and 73b may receive a first control signal (e.g., A). The input wiring patterns 73a and 73b may be electrically connected to the gate lines GT through the gate contacts CB. The output wiring patterns 74a and 74b may correspond to an output node (e.g., Y). The output wiring patterns 74a and 74b may be electrically connected to the drains of the transistors through the source/drain contacts CA.

According to the embodiment, the source/drain contact CA connected to the source of the NMOS transistor NMIc may receive the ground voltage VSS from the backside wiring pattern 76b through the first via VA, the first power rail 71a, and the backside via BVA, and receive the ground voltage VSS from the frontside wiring pattern 75b through the first via VA, the first power rail 71a, and the second via V1. As such, as the source of the NMOS transistor NMIc may receive the ground voltage VSS from the backside wiring pattern 76b and the frontside wiring pattern 75b in parallel, the resistance of the source of the NMOS transistor NMIc may decrease, and the performance of the integrated circuit 70 may be improved.

In addition, according to the embodiment, the source/drain contact CA connected to the source of the PMOS transistor PM1c may receive the power voltage VDD from the backside wiring pattern 76a through the first via VA, the second power rail 71b, and the backside via BVA and receive the power voltage VDD from the frontside wiring pattern 75a through the first via VA, the second power rail 71b, and the second via V1. As such, as the source of the PMOS transistor PM1c may receive the power voltage VDD from the backside wiring pattern 76a and the frontside wiring pattern 75a in parallel, the resistance of the source of the PMOS transistor PM1c may decrease, and the performance of the integrated circuit 70 may be improved.

In addition, according to the embodiment, as the integrated circuit 70 includes the first and fourth internal rails 72a and 72d receiving the ground voltage VSS, the source/drain contact CA connected to the source of the NMOS transistor NM1c of the first standard cell may further receive the ground voltage VSS from the frontside wiring pattern 75b through the first via VA, the first internal rail 72a, and the second via V1. The source/drain contact CA connected to the source of the NMOS transistor NMIc of the second standard cell may further receive the ground voltage VSS from the frontside wiring pattern 75b through the first via VA, the fourth internal rail 72d, and the second via V1. As such, as the source of the NMOS transistor NMIc may variously receive the parallel ground voltage VSS from the backside wiring pattern 76b and the frontside wiring pattern 75b, the resistance of the source of the NMOS transistor NMIc may further decrease, and the performance of the integrated circuit 70 may be improved even more.

In addition, according to the embodiment, as the integrated circuit 70 includes the second and third internal rails 72b and 72c receiving the power voltage VDD, the source/drain contact CA connected to the source of the PMOS transistor PM1c of the first standard cell may further receive the power voltage VDD from the frontside wiring pattern 75a through the first via VA, the second internal rail 72b, and the second via V1. The source/drain contact CA connected to the source of the PMOS transistor PM1c of the second standard cell may further receive the power voltage VDD from the frontside wiring pattern 75a through the first via VA, the third internal rail 72c, and the second via V1. As such, as the source of the PMOS transistor PM1c may variously receive the parallel power voltage VDD from the backside wiring pattern 76a and the frontside wiring pattern 75a, the resistance of the source of the PMOS transistor PM1c may further decrease, and the performance of the integrated circuit 70 may be improved even more.

However, the disclosure is not limited to the embodiments described above, and the frontside wiring layer of the integrated circuit may be connected to the internal rail, and the backside wiring layer may be connected to the source/drain region through the DBC. More specifically, an integrated circuit according to an embodiment may include a standard cell, and the standard cell may include a first frontside wiring layer, a gate line, a source/drain region, a second frontside wiring layer, and a backside wiring layer. The first frontside wiring layer may include a power rail and an internal rail which each extend in the first direction and are arranged apart from each other in the second direction. The gate line may be arranged under the first frontside wiring layer in the vertical direction and extend in the second direction. The source/drain region may be adjacent to the gate line in the first direction and may receive a supply voltage from the power rail. The second frontside wiring layer may be arranged on the first frontside wiring layer in the vertical direction. The backside wiring layer may be arranged under the source/drain region in the vertical direction. In this regard, the second frontside wiring layer may include a first frontside wiring pattern electrically connected to an internal rail, and the backside wiring layer may include a first backside wiring pattern electrically connected to the source/drain region.

In an embodiment, a power rail may be arranged to overlap a cell boundary of the standard cell, and the internal rail may be arranged in the standard cell. In an embodiment, the backside wiring layer may further include a second backside wiring pattern electrically connected to the power rail. In an embodiment, the second frontside wiring layer may further include a second frontside wiring pattern electrically connected to the power rail.

In an embodiment, the power rail may include a first power rail receiving a first voltage and a second power rail receiving a second voltage, and the backside wiring layer may include the second backside wiring pattern electrically connected to the first power rail and transmitting the first voltage to the first power rail and a third backside wiring pattern electrically connected to the second power rail and transmitting the second voltage to the second power rail. In an embodiment, the source/drain region may include a first source/drain region receiving the first voltage and a second source/drain region receiving the second voltage.

In an embodiment, the internal rail may include at least one of a first internal rail receiving a first voltage and a second internal rail receiving a second voltage, the first frontside wiring pattern may transmit the first voltage to the first internal rail, and the second frontside wiring layer may further include the second frontside wiring pattern electrically connected to the second internal rail and transmitting the second voltage to the second internal rail.

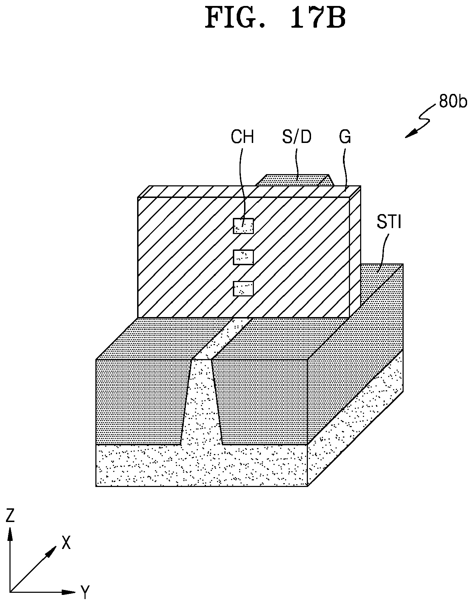

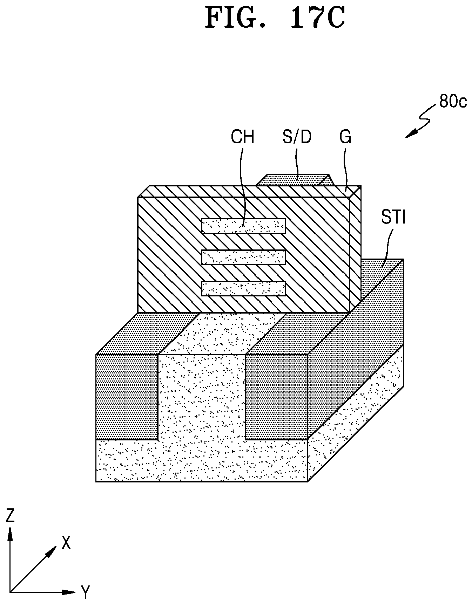

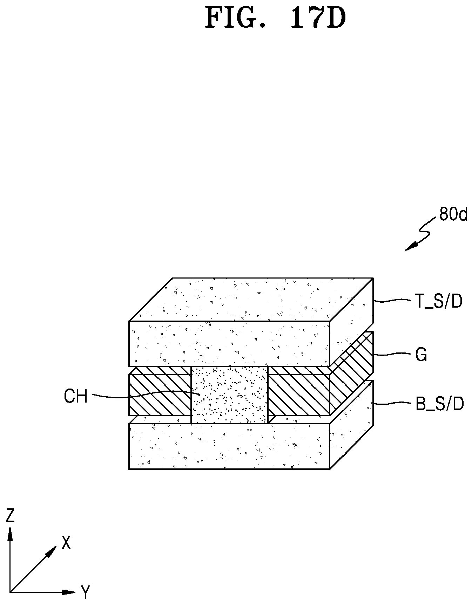

FIGS. 17A to 17D are diagrams of a device according to some embodiments. For example, FIG. 17 illustrates a FinFET 80a, FIG. 17B illustrates a GAAFET 80b, FIG. 17C illustrates an MBCFET 80c, and FIG. 17D illustrates a vertical FET (VFET) 80d. For convenience, one of two source/drain regions is not shown in FIGS. 17A to 17C, and FIG. 17D is a cross-sectional view of the VFET 80d cut by a plane which passes through a channel CH of the VFET 80d and is parallel with a plane formed by the second direction (Y) and the vertical direction (Z).

Referring to FIG. 17A, the FinFET 80a may be formed by an active pattern having a fin shape and extending in the first direction (X) between STIs and a gate G extending in the second direction (Y). A source/drain S/D may be formed on both sides of the gate G, and accordingly, a source and a drain may be spaced apart from each other in the first direction (X). An insulating film may be formed between the channel CH and the gate G. In some embodiment, the FinFET 80a may be formed by a plurality of active patterns arranged apart from each other in the second direction (Y) and the gate G.

Referring to FIG. 17B, the GAAFET 80b may be formed by active patterns arranged apart from each other in the vertical direction (Z) and extending in the first direction (X) (i.e., nanowires) and the gate G extending in the second direction (Y). A source/drain S/D may be formed on both sides of the gate G, and accordingly, a source and a drain may be spaced apart from each other in the first direction (X). An insulating film may be formed between the channel CH and the gate G. The number of nanowires included in the GAAFET 80b is not limited to the description of FIG. 17B.

Referring to FIG. 17C, the MBCFET 80c may be formed by active patterns arranged apart from each other in the vertical direction (Z) and extending in the first direction (X) (i.e., nanosheets) and the gate G extending in the second direction (Y). A source/drain S/D may be formed on both sides of the gate G, and accordingly, a source and a drain may be spaced apart from each other in the first direction (X). An insulating film may be formed between the channel CH and the gate G. The number of nanosheets included in the MBCFET 80c is not limited to the description of FIG. 17C.

Referring to FIG. 17D, the VFET 80d may include a top source/drain T_S/D and a bottom source/drain B_S/D which are arranged apart from each other in the vertical direction (Z) with the channel CH therebetween. The VFET 80d may include the gate G arranged between the top source/drain T_S/D and the bottom source/drain B_S/D and surrounding the circumference of the channel CH. An insulating film may be formed between the channel CH and the gate G.

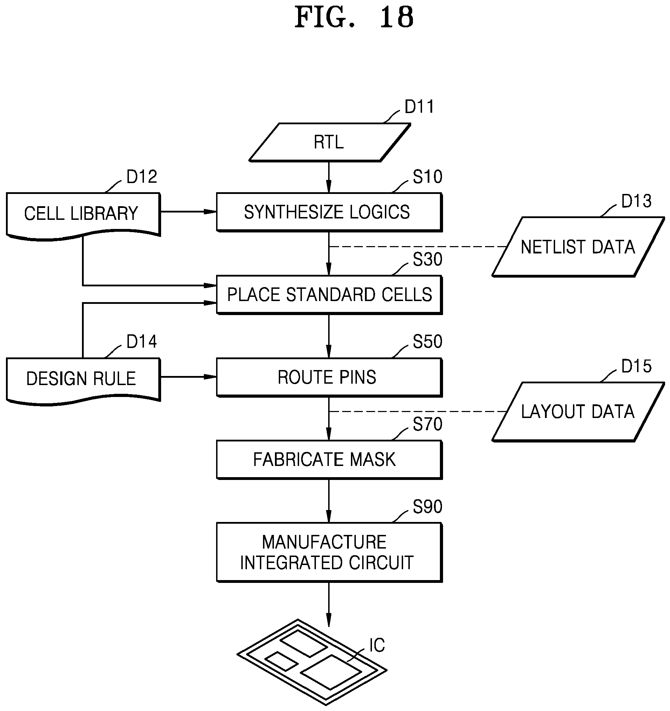

FIG. 18 is a flowchart illustrating a method of manufacturing an integrated circuit according to an embodiment.

Referring to FIG. 18, a method according to the embodiment is a method of manufacturing an integrated circuit including standard cells which includes a plurality of operations S10, S30, S50, S70, and S90. The standard cell may be a unit of layout included in the IC and may be designed to perform a predefined function. A cell library D12 (or a standard cell library) may include information about the standard cells (for example, information about functions, characteristics, layouts, etc.). In some embodiments, the cell library D12 may define not only function cells generating an output signal from an input signal but also tap cells and dummy cell. In some embodiments, the cell library D12 may define memory cell and dummy cells having the same footprint. A design rule D14 may include requirements with which a layout of an IC should comply. For example, the design rule D14 may include requirements regarding a space between patterns in the same layer, a minimum width of a pattern, a routing direction of a wiring layer, etc. In some embodiments, the design rule D14 may define a minimum space in the same track of a wiring layer.

In operation S10, the method of manufacturing an integrated circuit may include an operation of synthesizing a logic, to generate netlist data D13 from register-transfer level (RTL) data D11. For example, a semiconductor design tool (e.g., a logic synthesis tool) may perform the logic synthesis by referring to the cell library D12 from the RTL data D11 written in a hardware description language (HDL) such as VHSIC hardware description language (VHDL) or Verilog and may generate the netlist data D13 including bitstream or netlist. The netlist data D13 may correspond an input of placement and routing to be described later.

In operation S30, the standard cell may be placed. For example, a semiconductor design tool (e.g., P&R tool) may place the standard cells used in the netlist data D13 by referring to the cell library D12. In some embodiments, the semiconductor design tool may place the standard cells in a row extending in the X-axis direction or Y-axis direction, and the placed standard cells may receive power from a power rail extending along boundaries of the rows.

In operation S50, pins of the standard cell may be routed. For example, the semiconductor design tool may generate interconnections electrically connecting output pins and input pins of the placed standard cells and may generate layout data D15 defining the placed standard cells and the generated interconnections. The interconnection may include a via of a via layer and/or patterns of wiring layers. The wiring layers include a frontside wiring layer arranged on a front side of a substrate and a backside wiring layer arranged on a back side of a substrate. The layout data D15 may have a format such as GDSII and may include geometrical information of cells and interconnections. The semiconductor design tool may refer to the design rule D14 during the routing of the pins of the cells. The layout data D15 may correspond to an output of the placement and routing. Operation S50 may be solely (or collectively together with operation S30) referred to as a method of designing an integrated circuit.

In an embodiment, an integrated circuit may be designed to allow connection between a source of a transistor and a parallel power rail. For example, an integrated circuit in which a supply voltage is supplied to a source/drain contact connected to the source of the transistor through a frontside wiring layer and a power rail or through a backside wiring layer and a power rail may be designed. Thus, the source resistance of the transistor may decrease, and the performance of the integrated circuit may be improved without increasing the area of the integrated circuit.

In operation S70, an operation of fabricating a mask may be performed. For example, optical proximity correction (OPC) may be applied to the layout data D15 to correct distortion such as refraction, etc. due to properties of light in photolithography. Patterns on the mask may be defined to form the patterns on a plurality of layers based on the data to which the OPC is applied, and at least one mask (or a photomask) to form the patterns of each of the plurality of layers may be fabricated. In some embodiments, the layout of the integrated circuit may be limitedly modified in operation S70, and such limited modification of integrated circuit in operation S70 is a post processing for optimization of the structure of the integrated circuit and may be referred to as design polishing.

In operation S90, an operation of manufacturing an integrated circuit may be performed. For example, by patterning a plurality of layers using at least one mask fabricated in operation S70, an integrated circuit IC may be manufactured. A front-end-of-line (FEOL) may include, for example, an operation of planarizing and cleaning a wafer, an operation of forming a trench, an operation of forming a well, an operation of forming a gate line, and an operation of forming a source and a drain. Individual elements, for example, a transistor, a capacitor, a resistor, etc. may be formed on a substrate by the FEOL. In addition, a back-end-of-line (BEOL) may include, for example, an operation of silicidation of a source region and drain region, an operation of adding a dielectric, an operation of planarization, an operation of forming a hole, an operation of adding a metal layer, an operation of forming a via, an operation of forming a passivation layer, etc. Individual elements, for example, a transistor, a capacitor, a resistor, etc. may be connected by the BEOL. In some embodiments, a middle-of-line (MOL) may be performed between the FEOL and the BEOL, and contacts may be formed on the individual elements. Then, the integrated circuit may be packaged in a semiconductor package and may be used as a component of various applications.

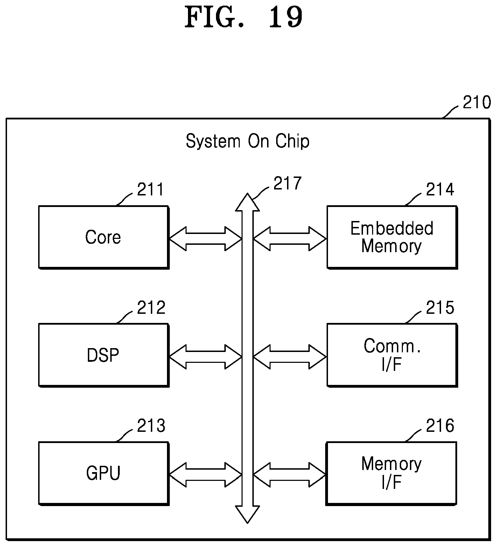

FIG. 19 is a block diagram of a system-on-chip (SoC) 210 according to an embodiment.

With reference to FIG. 19, a SoC 210 may refer to an integrated circuit in which components of a computing system or other electronic systems are integrated. For example, as an example of SoC 210, an application processor (AP) may include processors and components for other functions. The SoC 210 may include a core 211 (e.g., a processor), a digital signal processor (DSP) 212, a graphic processing unit (GPU), an embedded memory 214, a communication interface 215, and a memory interface 216. The components of the SoC 210 may communicate with each other through a bus 217.

The core 211 may process instructions and control operations of the components included in the SoC 210. For example, the core 211 may process a series of instructions to run an operating system and execute applications on the operating system. The DSP 212 may generate useful data by processing digital signals (e.g., a digital signal provided from the communication interface 215). The GPU 213 may generate data for an image output by a display device from image data provided from the embedded memory 214 or the memory interface 216, or may encode the image data. In some embodiments, the integrated circuit described in relation to the drawings may be included in the core 211, the DSP 212, the GPU 213, and/or the embedded memory 214.

The embedded memory 214 may store data necessary for the core 211, the DSP 212, and the GPU 213 to operate. The communication interface 215 may provide an interface for a communication network or one-to-one communication. The memory interface 216 may provide an interface for an external memory of the SoC 210, such as a dynamic random access memory (RAM) (DRAM), a flash memory, etc.

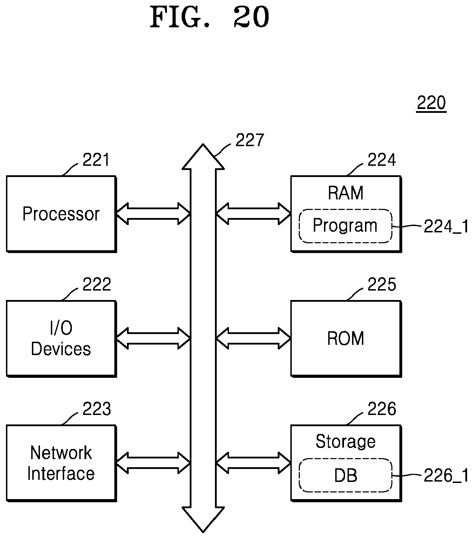

FIG. 20 is a block diagram of a computing system 220 including a memory storing a program according to an embodiment.

Referring to FIG. 20, at least part of the operations illustrated in the flowchart of method of designing an integrated circuit according to embodiments may be performed in a computing system (or computer) 220. The computing system 220 may be a fixed computing system such as a desktop computer, a workstation, a server, etc., or a portable computing system such as a laptop computer, etc. The computing system 220 may include a processor 221, input/output (I/O) devices 222, a network interface 223, a RAM 224, a read only memory (ROM) 225, and a storage 226. The processor 221, the I/O devices 222, the network interface 223, the RAM 224, the ROM 225, and the storage 226 may be connected to a bus 227, and communicate with each other through the bus 227.

The processor 221 may be referred to as a processing unit and include at least one core capable of executing an instruction set (e.g., Intel Architecture (IA)-32, 64 bit extension IA-32, x86-64, PowerPC, Sparc, MIPS, ARM, IA-64, etc.), such as a micro-processor, an AP, a DSP, and a GPU. For example, the processor 221 may access the memory, i.e., the RAM 224, or ROM 225 through the bus 227, and execute instructions stored in the RAM 224 or ROM 225.

The RAM 224 may store at least a program 224_1 for a method of designing an integrated circuit according to an embodiment of the disclosure or at least a part thereof, and by the program 224_1, the processor 221 may perform a method of designing an integrated circuit for example, at least some of the operations included in FIG. 18. That is, the program 224_1 may include a plurality of instructions executable by the processor 221, and the plurality of instructions included in the program 224_1 may make the processor 221 perform, for example, at least some of the operations included in the aforementioned flowcharts.

The storage 226 may not lose stored data even when the power supplied to the computing system 220 is cut. The storage 226 may store the program 224_1 according to an embodiment of the disclosure, and the program 224_1 or at least a part thereof may be loaded to the RAM 224 from the storage 226 before the program 224_1 is executed by the processor 221. Alternatively, the storage 226 may store a file written in a program language, and the program 224_1 generated by a compiler, etc. or at least a part thereof may be loaded to the RAM 224 from the file. In addition, the storage 226 may store database (DB) 226_1, and the store database 226_1 may include information required for designing an integrated circuit (for example, information about designed blocks, the cell library D12 of FIG. 18, and/or the design rule D14).

The storage 226 may store data to be processed by the processor 221 or data processed by the processor 221. That is, the processor 221 may generate data by processing data stored in the storage 226 according to the program 224_1 and store the generated data in the storage 226. For example, the storage 226 may store the RTL data D11, the netlist data D13, and/or the layout data D15 of FIG. 18.

The I/O devices 222 may include an input device such as a keyboard, a pointing device, etc., and may include an output device such as a display device, a printer, etc. For example, through the I/O devices 222, the execution of the program 224_1 may be triggered by the processor 221, the RTL data D11 and/or the netlist data D13 of FIG. 18 may be input, and the layout data D15 of FIG. 18 may be checked. The network interface 223 may provide access to a network outside the computing system 220.

At least one of the devices, units, components, modules, or the like represented by a block or an equivalent indication in the above embodiments including, but not limited to, FIGS. 18-20, may be physically implemented by analog and/or digital circuits including one or more of a logic gate, an integrated circuit, a microprocessor, a microcontroller, a memory circuit, a passive electronic component, an active electronic component, an optical component, and the like, and may also be implemented by or driven by software and/or firmware (configured to perform the functions or operations described herein).

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. An integrated circuit comprising:
a power rail extending in a first direction and configured to receive a supply voltage;
a gate line below the power rail and extending in a second direction that intersects the first direction;
a source/drain region adjacent to the gate line in the first direction and configured to receive the supply voltage from the power rail;
a frontside wiring layer above the power rail, connected to the power rail, and configured to transmit the supply voltage to the power rail; and
a backside wiring layer below the power rail, connected to the power rail, and configured to transmit the supply voltage to the power rail.

2. The integrated circuit of claim 1, further comprising a backside via extending in a vertical direction on the backside wiring layer,
wherein the backside wiring layer is connected to the power rail through the backside via.

3. The integrated circuit of claim 2, further comprising:
a contact extending in the vertical direction on the backside via; and
a contact via on the contact,
wherein the backside wiring layer is connected to the power rail through the backside via, the contact, and the contact via.

4. The integrated circuit of any one of claims 1, 2, or 3, further comprising a power rail via on the power rail,
wherein the frontside wiring layer is connected to the power rail through the power rail via.

5. The integrated circuit of any one of claims 1 to 4, wherein the frontside wiring layer at least partially overlaps the backside wiring layer.

6. The integrated circuit of any one of claims 1 to 5, wherein the supply voltage comprises a first voltage and a second voltage,
wherein the power rail comprises:
a first power rail configured to receive the first voltage; and
a second power rail configured to receive the second voltage,
wherein the source/drain region comprises:
a first source/drain region configured to receive the first voltage; and
a second source/drain region configured to receive the second voltage,
wherein the frontside wiring layer comprises:
a first frontside wiring pattern connected to the first power rail and configured to transmit the first voltage to the first power rail; and
a second frontside wiring pattern connected to the second power rail and configured to transmit the second voltage to the second power rail, and
wherein the backside wiring layer comprises:
a first backside wiring pattern connected to the first power rail and configured to transmit the first voltage to the first power rail; and
a second backside wiring pattern electrically connected to the second power rail and configured to transmit the second voltage to the second power rail.

7. The integrated circuit of claim 6, wherein each of the first backside wiring pattern and the second backside wiring pattern extends in the first direction.

8. The integrated circuit of claim 6 or 7, wherein each of the first backside wiring pattern and the second backside wiring pattern extends in the second direction, and
wherein each of the first backside wiring pattern and the second backside wiring pattern is arranged in a line in the second direction.

9. The integrated circuit of claim 6, 7 or 8, wherein each of the first backside wiring pattern and the second backside wiring pattern extends in the second direction, and
wherein the first backside wiring pattern is spaced apart from the second backside wiring pattern the first direction.

10. The integrated circuit of any one of claims 1 to 9, comprising:
a source region;
a drain region spaced apart from the source region in a first direction;
a gate line between the source region and the drain region, the gate line extending in a second direction that intersects to the first direction;
a frontside wiring layer above the gate line; and
a backside wiring layer below the gate line,
wherein the frontside wiring layer comprises a first frontside wiring pattern extending in the first direction, connected to the source region, and configured to transmit a supply voltage to the source region, and
wherein the backside wiring layer comprises a first backside wiring pattern connected to the source region and configured to transmit the supply voltage to the source region.

11. An integrated circuit comprising:
a source region;
a drain region spaced apart from the source region in a first direction;
a gate line between the source region and the drain region, the gate line extending in a second direction that intersects to the first direction;
a frontside wiring layer above the gate line; and
a backside wiring layer below the gate line,
wherein the frontside wiring layer comprises a first frontside wiring pattern extending in the first direction, connected to the source region, and configured to transmit a supply voltage to the source region, and
wherein the backside wiring layer comprises a first backside wiring pattern connected to the source region and configured to transmit the supply voltage to the source region.

12. The integrated circuit of claim 11, further comprising a backside via on the backside wiring layer,
wherein the backside wiring layer is connected to the source region through the backside via.

13. The integrated circuit of claim 10 or 11, further comprising:
a contact on the source region; and
a contact via on the contact,
wherein the first frontside wiring pattern is connected to the source region through the contact via and the contact.

14. The integrated circuit of claim 10, 11 or 12, wherein the frontside wiring layer further comprises a second frontside wiring pattern connected to the drain region and extending in the first direction, optionally wherein the second frontside wiring pattern at least partially overlaps the first backside wiring pattern.

15. The integrated circuit of any one of claims 10 to 14, wherein the backside wiring layer further comprises a second backside wiring pattern,
wherein the first backside wiring pattern is configured to receive a first voltage, and
wherein the second backside wiring pattern is configured to receive a second voltage.
